# EUROPEAN PATENT SPECIFICATION

(11) **EP 2 972 588 B1**
(45) Date of publication and mention of the grant of the patent: **16.11.2016**
(21) Application number: 14715553.5
(22) Date of filing: 13.03.2014
(51) Int. Cl.: G03F 7/20

(54) **SYNCHRONIZED LASER SCANNING SYSTEM AND METHOD OF PROVIDING THE SAME**
SYNCHRONISIERTES LASERABTASTSYSTEM UND VERFAHREN ZUR DESSEN BEREITSTELLUNG
SYSTÈME DE BALAYAGE LASER SYNCHRONISÉ ET PROCÉDÉ DE FOURNITURE DUDIT SYSTÈME

(30) Priority: 15.03.2013 US 201361793332 P; 15.03.2013 US 201361792227 P
(43) Date of publication of application: 20.01.2016
(73) Proprietor: Micronic Mydata AB, 183 03 Täby (SE)
(72) Inventor: STENSTRÖM, Pontus, S-184 92 Åkersberga (SE); HARTMAN, Carl, S-752 40 Uppsala (SE); SANDSTRÖM, Torbjörn, S-435 43 Pixbo (SE)
(86) International application number: PCT/EP2014/054988
(87) International publication number: WO 2014/140193

(56) References cited:
- US-A1- 2005 270 631
- "AD9852 CMOS 300 MSPS Complete DDS (data sheet, Rev. E 05/2007)", , 1 May 2007 (2007-05-01), pages 1-52, XP055136168, Norwood MA, US Retrieved from the Internet: URL:www.analog.com/static/imported-files/d ata_sheets/AD9852.pdf [retrieved on 2014-08-22]
- Anonymous: "FAQs/RAQs | AD9852 | Direct Digital Synthesis (DDS) & Modulators | RF / IF ICs | Analog Devices", , 28 August 2014 (2014-08-28), XP055137027, Retrieved from the Internet: URL:http://www.analog.com/en/rfif-componen ts/direct-digital-synthesis-dds/ad9852/pro ducts/faqs/FAQ_Why_did_the_model_numbers_c hg_on_the_AD9852_54/resources/faq.html?dis play=popup [retrieved on 2014-08-28]

## Description

### RELATED APPLICATION

This application claims the benefit of US Provisional Patent Application No. 61/793,332, filed on 15 March 2013 and US Provisional Patent Application No. 61/792,227, filed on 15 March 2013.

This application is related to US Provisional Application Nos. 61/777,978 entitled "METHOD AND DEVICE FOR WRITING PHOTOMASKS WITH REDUCED MURA ERRORS", 61/777,144 entitled "OPTICAL WRITER FOR FLEXIBLE FOILS", 61/776,693 entitled "METHOD AND DATA PATH USING PATTERN AWARE HEALING" and 61/777,469 entitled "MECHANICALLY PRODUCED ALIGNMENT FIDUCIAL METHOD AND DEVICE".This application is related to the following US Patent documents: US20100208329A1, US20100142757A1, US6975443B2, US7110159, and US7790350B2.

### BACKGROUND

The disclosed invention relates to pattern generation, direct-write lithography and to optical writing of patterns on a photosensitive surface in general. In particular it relates to the patterning of photomasks, wafers, PCBs, fine-pitch interconnection substrates, flexible substrates with or without active components (transistors) and/or of panels for displays, photovoltaics and illumination. Other patterns with line widths from 0.03 to 10 microns may also use the technology disclosed. In particular the technology relates to high-precision pattern generators and direct writers using acoustooptic modulation. It also relates to optical patterning with a writing system with a onedimensional field. The one-dimensional field can be created by scanning, e.g. acoustooptic or electrooptic scanning, scanning by a rotating polygon, prism or hologram, or by a vibrating mirror; or it can be created by a row of light sources or by using a onedimensional spatial light modulator SLM. The crosswise movement can be created by a relative motion between the writing system and the workpiece or by a scanning optical system which scans only the optical field relative to the workpiece.

The invention defines a method of providing a synchronized laser scanning system in claim 1, and a synchronized laser scanning system in claim 22.

Acoustooptic modulation is commonly used in laser scanners, providing a reasonable compromise between cost, speed and efficiency. The laser scanner using an AOM modulator may have a single beam or multiple and after the modulation of the beam it may be scanned by electrooptic or mechanical means. Prior art exists in the form of polygon scanners from Applied Materials (USA) and Orbotech (Israel), and acoustooptic scanners from Micronic-Mydata (Sweden) and Heidelberg Instruments (Germany), all of them employing acoustooptic multibeam modulation. One-dimensional writers using SLMs are commercially available from Dainippon Screen (Japan) and Micronic-Mydata (Sweden).

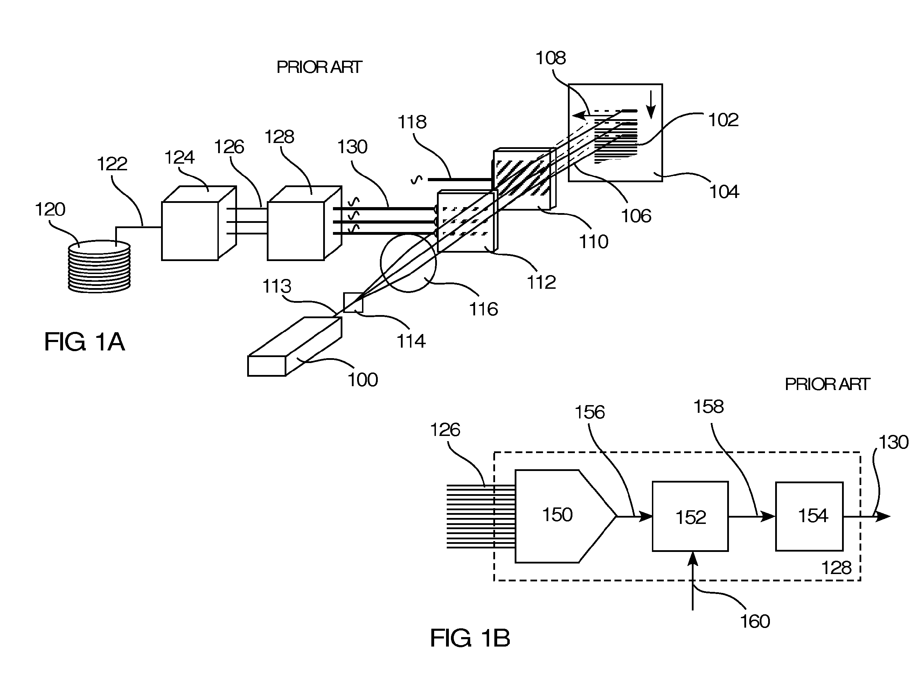

A multibeam laser scanner as known in prior art is shown in **FIG. 1A**. A laser 100 emits a beam113 which is divided into multiple beams 116 by a beam-splitter 114. Each beam is modulated by a multibeam acoustooptic moulator 112 and deflected by a deflector 110 (could also be a polygon, galvo mirror, etc), so that it scans 108 over the
surface of the workpiece. The optics is symbolically shown as a single lens 116. The multibeam modulator accepts a modulated RF signal 130 for each beam which is generated in the RF driver 128 which modulates the video 126 on an RF carrier. The RF is typically amplitude modulated with the carrier. The input pattern is stored in memory 120 and converted by a rasterizer 124 to the video used by the RF driver.

**FIG. 1B** shows the RF driver in more detail. The input is a digital signal 126 which contains gray values for each pixel. The gray values are converted to an analog voltage 156 by the DAC 150. The analog voltage, typically ranging from 0 to 1 volt modulates the carrier 160 from the local oscillator to produce a low-level modulated RF 158 which is then amplified in an RF amplifier to a power level suitable for the acoustooptic modulator, often 1 - 5 watts per channel.

Prior art document US-A1-2005/270631 discloses a method of laser scanning involving operating an acousto-optic modulator via a transducer to write on a workpiece. The radiofrequency driver may generate the modulated RF signal for driving the AOM using a Model AD9852ASQ direct digital synthesizer manufactured by Analog Devices, Inc.

### BRIEF DESCRIPTION OF THE DRAWINGS

**FIG. 1A** shows a multibeam laser scanner as known in prior art.
**FIG. 1B** shows the RF driver in more detail.
**FIG. 1C** shows a dark area with three smaller areas which should be exposed.
**FIG. 1D** shows a reversal of the the phase between stretches of pixels that are not dark in order to increase the resolution of the writer.
**FIG. 1E** shows a shows a pattern defined as a binary raster grid.
**FIGS. 2A-D** show the generation of the modulated RF to drive the AOM in a prior art laser scanner.
**FIGS. 3A-D** shows the generation of the modulated RF to be used in **FIG. 1D**.
**FIG. 3E** shows the detail RF waves with a negative amplitude are used in **FIG. 1D**.
**FIG. 4** shows the RF driver needed to create the same complex amplitudes on the RF signal. This can be done by analog circuits as shown in **FIG. 4**.
**FIG. 5** shows an example view of a novel RF driver usable with the invention.
**FIG. 6** shows the clocks in a fully synchronous writer using acoustooptic modulation and scanning and also contains generation of the RF for the AOD, which follows similar principles.
**FIG. 7** shows an example fully synchronous system with the parameters described in the specification.
**FIG. 8** shows three pixels.
**FIG. 9** shows three example pixels showing phase modulation.
**FIG. 10** shows phase reversal between the pixels.
**FIG. 11** shows two on pixels with a black pixel in between.
**FIGS. 12****,****13****,****14** and **15** show one of the possible methods to write gray.
**FIGS. 16** and **17** show how the gray pixels are divided into two parts and the amplitudes are calculated to give the desired pixel exposure dose and as constant RF power as possible.
**FIGS. 18A-18C** show increased resolution in one direction and a number of patterns that would benefit from it.
**FIGS. 19A-19C** show a conventional laser writer using acoustooptic modulation and explains the phenomenon of scophony.
**FIGS. 20A-20C** show a one-dimensional writer based on a linear SLM and an example of micro mirrors useful to practice the technology disclosed.
**FIGS. 21A-21B** **and** **FIGS 22A - 22C** show more details of the innovative rasterization for increased resolution.

### DETAILED DESCRIPTION

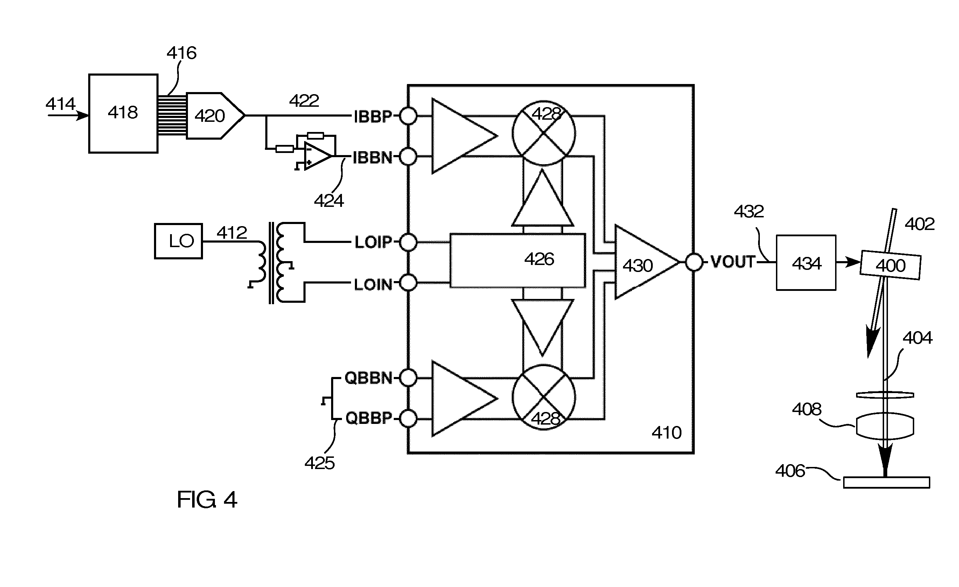

The novel RF driver described below avoids the analog complexity of the balanced mixer modulator shown in **FIG. 4**. Complexity is reduced by constructing a modulated wave form in the numeric domain and converting digital amplitude values directly to RF using a fast digital-to-analog converter ("DAC"). Some aspects of the technology disclosed can be used with either the novel RF driver or a balanced mixer modulator.

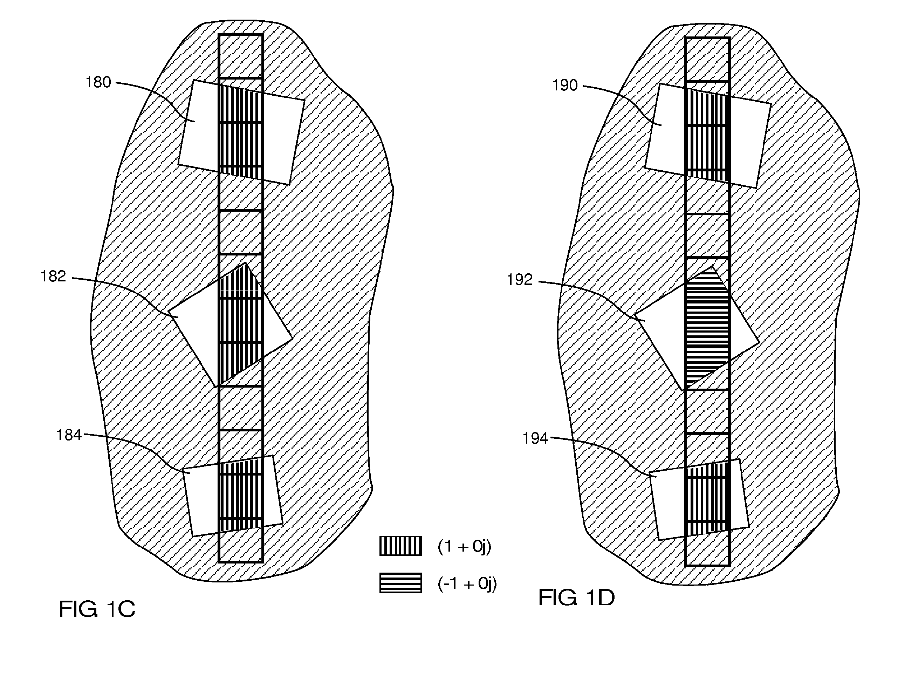

**FIG. 1C** shows a dark area with three smaller areas 180, 182, 184 which should be exposed. The vertical column is the pixels along the scan line. Each pixel has a gray value which is calculated from the overlap of the areas to be exposed and the pixel area. Details may vary and there may be non-linear look-up functions, but in essence the area overlaps controls the gray value of the pixels. **FIG. 1C** therefore has dark pixels between the exposed areas, fully turned on pixels and pixels with partial overlap which are rendeded as gray.

The problem of improving the resolution in an optical writer having a one-dimensional field by up to a factor of two with essentially unchanged optics can be solved by organizing the pattern such that the need for resolved fine pitch lines is essentially confined to one direction (+/- 30 degrees), and orienting the fine pitch lines perpendicular to the one-dimensional field. In some implementations, this includes providing pixels along the one-dimensional field which have the ability to create phases other than zero, illuminating two or more adjacent pixels coherently and driving the pixels to incur to the light both positive and negative phases, in particular to make illuminated portions along the one-dimensional field with dark areas in between have reversed phases, i.e. a phase difference of more than 90 degrees, preferably close to 180 degrees. In particular, the light representing turned-on pixels should preferably be modulated to either of the phases 0 and 180 degrees and the magnitude should vary between zero and a maximum value. As usual in optics, a constant phase can be arbitrarily added or subtracted to all phase values to make one of the phases have the reference value 0 degrees.

One aspect of the technology disclosed is to use an acoustooptic modulator and the phenomenon of scophony as explained below to create the equivalent of pixels in the written pattern, and to use complex modulation of the RF wave driving the modulator crystal to incur to the light the desired magnitude and phase for each pixel.

A third aspect of the technology disclosed is that the resolution enhancement can be controlled by software and a writer can be built which has a first mode of operation where the optical properties are similar in x and y and a second mode where the resolution is approximately doubled in y while the resolution in x remains the approximately the same.

A fourth aspect of the technology disclosed is that the pattern is rasterized with reversed phases on a one-dimensional field by field basis, either from vector data directly or from pre-rasterized data without phase reversals.

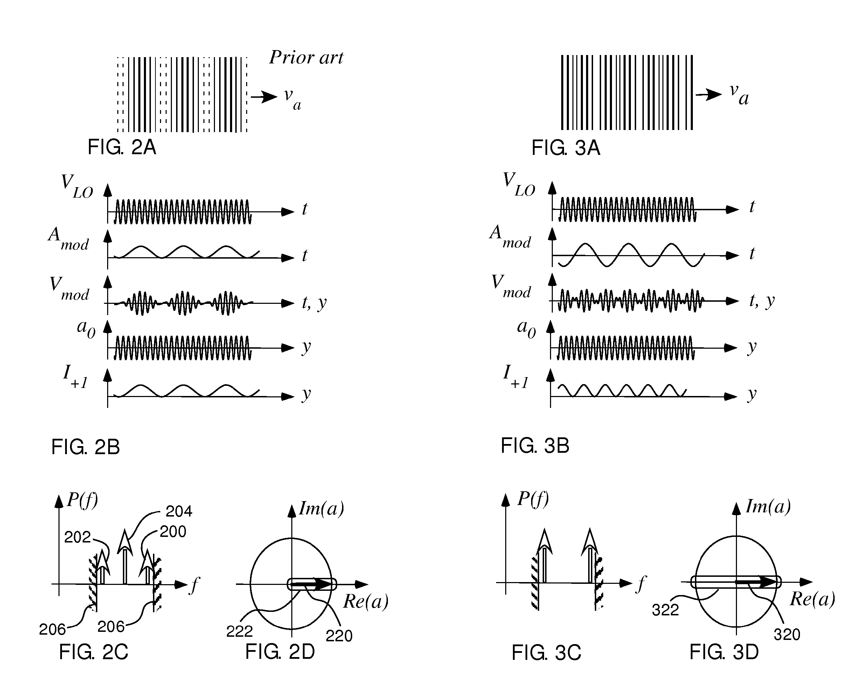

We propose to reverse the phase between the stretches of pixels that are not dark in order to increase the resolution of the writer. This is shown in **FIG. 1D** with the areas 190, 192 and 194. The complex amplitude to be used of each exposed area is shown in the legend. **FIGS. 2A-D** shows the generation of the modulated RF to drive the AOM in a prior art laser scanner.

A first mode of carrying out the Improved Optical Writer technology is to add a balanced mixer to the RF modulator of an acoustooptically modulated scanner, adjusting the scanning for the scophonic condition and rasterize the data following the guidelines given in this specification.

A second mode of carrying out the Improved Optical Writer technology is to configure a one-dimensional SLM in a pattern generator or direct writer to give phase modulation to the light and to rasterize the input data according to the guidelines given in this specification.

A third mode is to use either of the two modes given above and write features with high resolution in a first direction, physically rotate the workpiece, align it to the first pattern and write a second set of features with high resolution in a second direction, typically perpendicular to the first direction.

A fourth mode of operation is to write a set of narrow lines with the methods put forward in this specification and then multiply the pitch by chemical methods,
in particular by directed self-assembly.

A fifth mode of carrying out the Improved Optical Writer technology is to rasterized the input pattern to an area-sampled bitmap, then extract a single column of pixel values, finding phase switch points where the illumination is intended to be low, and switch the phase between 0 and 180 degrees at phase switch points.

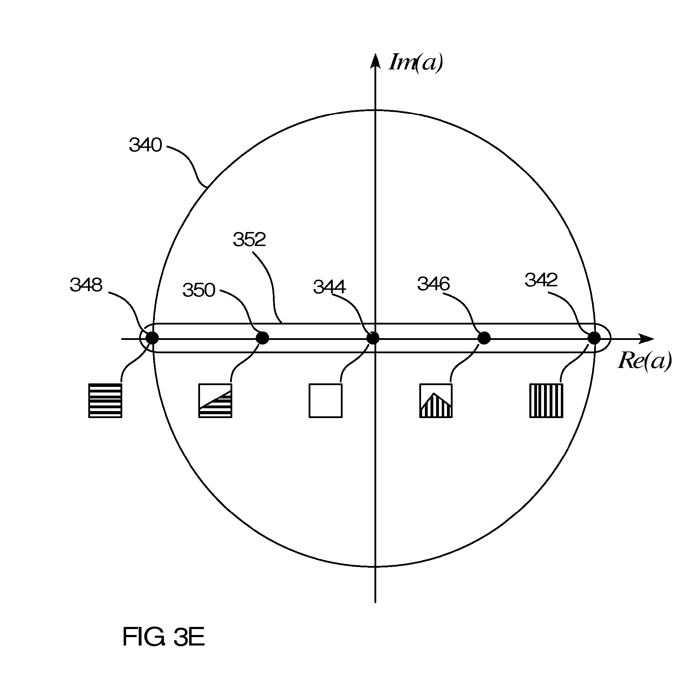

Returning to this technology, the generation of the modulated RF to be used in **FIG. 1D** is shown in **FIGS. 3A-D**. Comparison of the complex plane in **FIG. 2D** and **FIG. 3D** shows that RF waves with a negative amplitude are used in **FIG. 1D**. This is detailed in **FIG. 3E**. The figure shows five pixels with different amount of overlap with the exposed figure and positive phase 342, 346 and negative phase 348, 350. Where there is no overlap, the pixel should be dark 344. In principle it would be possible to use pixels with complex amplitude anywhere withing the unit circle 340, but for pixels with amplitudes along the real axis 352 give better quality. **FIG. 3E** shows the desired real amplitudes of the light impinging on the workpiece for the illustrated features. However, complex amplitude values come from the modulated RF signals. Therefore, the RF driver needs to create the same complex amplitudes on the RF signal. This can be done using the analog circuit shown in **FIG. 4**. A balanced mixer mixes quadrature inputs on the local oscillator LO. More details are given in the application that describes the Improved Optical Writer technology.

Another aspect of the present technology is to provide a fully synchronised laser scanner where the writing of the pixel data is synchronized with the generation of the RF for the acoustooptic deflector and both AOM and AOD frequencies and synchronized with the same master clock as the data output. Using the same master clock enables the scan cycle and data output to be controlled simultaneously without timing errors associated with having different time bases.

A third aspect of the present technology is that the power dissipation in the AOM channels are kept nearly constant by a fast phase modulation of the RF and consequently of the light beams as a way of turning the beam off in dark areas. The phase modulation is too fast to be be optically resolved and extinguishes the beams in the lens aperture at constant RF power to the modulator transducer.

A fourth aspect of the present technology is that a beam is extinguished in dark areas by fast periodic phase switching (reversal) and that gray pixels are written with gray (intermediate) power.

A fifth aspect of the present technology is that a pixel is written by two different subpixels which together give the desired gray value and more constant power dissipation between different pixels than a uniform gray value in the would.

A further aspect of the present technology is to provide a system with highly accurate optical writing of a pattern on a workpiece by means of at least one acoustooptically modulated laser beam comprising a rasterizer converting input vector data to a pixel bitmap, a numerical modulator computing sampled values of an RF carrier modulated with pixel data, a fast DAC for comverting sampled values to an RF signal fed to an acoustooptical modulator

A further aspect of the technology disclosed is to provide a system as described above wherein the pixel data is calculated to represent an RF signal with 0 and 180 degrees of phase.

A further aspect of the technology disclosed is to provide a system as described above wherein the pixel data is calculated to represent an RF signal with additional phases 90 and 270 degrees.

A further aspect of the technology disclosed is to provide a system as in any of the preceding descriptions wherein the phase of the RF changes within a pixel.

A further aspect of the technology disclosed is to provide a system with highly accurate optical writing of a pattern on a workpiece by means of at least one acoustooptically modulated laser beam comprising a rasterizer converting input vector data to a pixel bitmap, a numerical modulator computing sampled values of an RF carrier modulated with pixel data, a fast DAC for converting sampled values to an RF signal fed to an acoustooptical modulator, a first clock controlling the loading of the pixel of the data and a second clock controlling the sampling of the RF signal, where the frequency of the second clock is an integer times the first clock frequency.

A further aspect of the technology disclosed is to provide a system with highly accurate writing of a pattern on a workpiece by means of at least one acoustooptically modulated laser beam scanned by an acoustooptic deflector comprising a rasterizer converting input vector data to a pixel bitmap, a numerical modulator computing sampled values of an RF carrier modulated with pixel data, a fast DAC for converting sampled values to an RF signal fed to an acoustooptical modulator, a first clock signal controlling the loading of the pixel data and a second clock signal controlling the sampling of the modulator RF signal, a third clock signal controlling the loading of frequency data for the acoustooptic deflector, and a fourth clock signal controlling the sampling of the RF to the deflector, where all four clock signals are synchronized.

A further aspect of the technology disclosed is to provide a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of dark pixels are modulated by rapid flipping of the phase between 0 and 180 degrees.

A further aspect of the technology disclosed of providing a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of dark pixels are modulated by rapid flipping of the phase between 0 and 180 degrees may be used in a system and method for writing fine-pitch patterns in an optical writer having a one-dimensional optical field with a lengthwise and crosswise direction that scans in the crosswise direction, the method including: receiving a pattern in which fine pitch lines are constrained to run within 30 degrees of parallel to the crosswise direction of the optical field, wherein the one-dimensional optical field is partially coherent in the lengthwise direction, rasterizing a pattern such that transitions in the pattern across the lengthwise direction from light to dark cause a reversal in a sign of the real part of an amplitude of pixel data generated by the rasterization and modulating light in the one-dimensional optical field to a complex amplitude where the real part of the complex amplitude follows the sign of the pixel data; whereby line-space patterns down to about 0.25 * wavelength/NA can be resolved.

A further aspect of the technology disclosed of providing a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of dark pixels are modulated by rapid flipping of the phase between 0 and 180 degrees may be used in a system and method for writing fine-pitch patterns in an optical writer having a one-dimensional optical field with a lengthwise and crosswise direction that scans in the crosswise direction, and where the fine pitch lines are further constrained to run within 15 degrees of parallel to the crosswise direction.

A further aspect of the technology disclosed of providing a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of dark pixels are modulated by rapid flipping of the phase between 0 and 180 degrees may be used in a system and method for writing fine-pitch patterns in an optical writer having a one-dimensional optical field with a lengthwise and crosswise direction that scans in the crosswise direction, further including the actions of providing a second writing mode where a rasterizer renders to pixel data with to have only non-negative real parts of the amplitude; and switching between the modes by changing the algorithm used by the rasterizer, whereby the new high resolution mode is added to a system without sacrificing the flexibility and image quality of the conventional writing.

A further aspect of the technology disclosed of providing a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of dark pixels are modulated by rapid flipping of the phase between 0 and 180 degrees may be used in a system and method for creating a partially coherent writing condition in a raster-scanning laser writer, including the actions of providing an acoustooptic modulator having an acoustic velocity, using projection optics with a demagnification factor makes the beam on the workpiece cover at least two pixels, and further scanning the beam over the workpiece with a velocity which approximately matches the acoustic velocity in the modulator divided by the demagnification factor, whereby a stationary image of the pixels in the modulator is formed on the workpiece with interference between adjacent pixels but not over long distances.

A further aspect of the present technology is to provide a system with highly accurate optical writing of a pattern on a workpiece by means of at least one acoustooptically modulated laser beam comprising a rasterizer converting input vector data to pixel data, an RF modulator creating an RF signal modulated with pixel data, the RF signal being fed to the acoustooptical modulator, where the pixel data of gray pixels are modulated by dividing the pixel into two parts and modulating the two parts with different amplitudes calculated to reduce the variation in RF power in the acoustooptic modulator.

In further aspects, the technology disclosed of digitally computing sample points of a wave form with wave form amplitude modulation and phase control that represent image pattern data, using a DAC for converting the digital wave form sample points to an analog RF refquency signal and applying the analog RF signal to an AOM transducer to modulate a laser beam to create an image may be used in a system and method for writing fine-pitch patterns in an optical writer having a one-dimensional optical field with a lengthwise and crosswise direction that scans in the crosswise direction, the method including: receiving a pattern in which fine pitch lines are constrained to run within 30 degrees of parallel to the crosswise direction of the optical field, wherein the one-dimensional optical field is partially coherent in the lengthwise direction, rasterizing a pattern such that transitions in the pattern across the lengthwise direction from light to dark cause a reversal in a sign of the real part of an amplitude of pixel data generated by the rasterization and modulating light in the one-dimensional optical field to a complex amplitude where the real part of the complex amplitude follows the sign of the pixel data; whereby line-space patterns down to about 0.25 * wavelength/NA can be resolved.

In further aspects, the technology disclosed of digitally computing sample points of a wave form with wave form amplitude modulation and phase control that represent image pattern data, using a DAC for converting the digital wave form sample points to an analog RF refquency signal and applying the analog RF signal to an AOM transducer to modulate a laser beam to create an image may be used in a system and method for writing fine-pitch patterns in an optical writer having a one-dimensional optical field with a lengthwise and crosswise direction that scans in the crosswise direction, and where the fine pitch lines are further constrained to run within 15 degrees of parallel to the crosswise direction.

In further aspects, the technology disclosed of digitally computing sample points of a wave form with wave form amplitude modulation and phase control that represent image pattern data, using a DAC for converting the digital wave form sample points to an analog RF refquency signal and applying the analog RF signal to an AOM transducer to modulate a laser beam to create an image may be used in a system and method for writing fine-pitch patterns in an optical writer having a one-dimensional optical field with a lengthwise and crosswise direction that scans in the crosswise direction, further including the actions of providing a second writing mode where a rasterizer renders to pixel data with to have only non-negative real parts of the amplitude; and switching between the modes by changing the algorithm used by the rasterizer, whereby the new high resolution mode is added to a system without sacrificing the flexibility and image quality of the conventional writing.

In further aspects, the technology disclosed of digitally computing sample points of a wave form with wave form amplitude modulation and phase control that represent image pattern data, using a DAC for converting the digital wave form sample points to an analog RF refquency signal and applying the analog RF signal to an AOM transducer to modulate a laser beam to create an image may be used in a system and method for creating a partially coherent writing condition in a raster-scanning laser writer, including the actions of providing an acoustooptic modulator having an acoustic velocity, using projection optics with a demagnification factor makes the beam on the workpiece cover at least two pixels, and further scanning the beam over the workpiece with a velocity which approximately matches the acoustic velocity in the modulator divided by the demagnification factor, whereby a stationary image of the pixels in the modulator is formed on the workpiece with interference between adjacent pixels but not over long distances.

### Technical Problem

The technology disclosed can be applied to provide a modulation system with performance close to theoretical maximum and with negligible drift, jitter and ageing. It is desirable to use as little calibration as possible, but when calibration is needed the hardware should allow the calibration to be precise and stable.

### Technical Solution

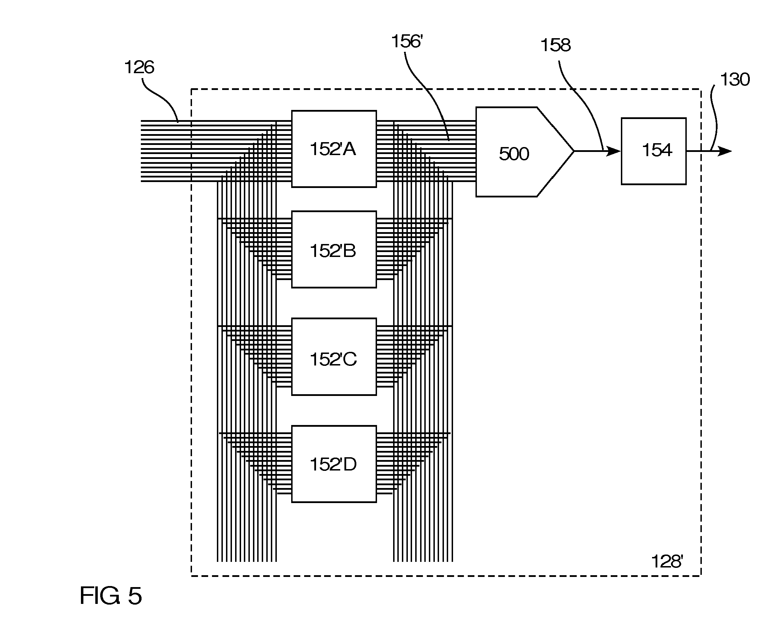

**FIG. 5** shows an example view of a novel RF driver usable with the invention. The digital pixel data 126 is input and distributed among a number of FPGAs 152A-D (4 shown, 8 may be more likely in a real system, the DAC vendor's reference design uses 12). The FPGAs each calculate one amplitude value and they are multiplexed to the high-speed DAC which runs at a much higher clock. Thus each FPGA may contribute every fourth, eighth, etc. value to the DAC. The output from the DAC is amplified in a RF power amplifier to the power level needed by the AOM channel, typically between 1 and 5 watts. It is possible to structure the system differently, e.g., to divide the calculation of the voltage sample values in a first step where a complex amplitude is calculated (in some example implementations with the imaginary part being identical to 0) and a second step where the complex amplitude is numerically modulated (typically multiplied with) on to the digitally described carrier waveform and voltage samples are sent to the fast RF DAC.

Implementations of the technology disclosed benefit from some or all of flexibility, robustness and performance, possibly also in cost as compared to other systems. The resolution of an acoustooptic scanner depends to great degree on the details of the modulating waveform and there may be room for continuous development of the modulation of the pixels. Multiple writing modes may be needed in different situations and special test modes can be foreseen to be developed. In the invention the modulation is defined by software or firmware which can be simply updated. Updates to the RF modulation parameters can be distributed electronically and updated in writing systems in the field. There are also benefits in terms of robustness, since there is very little RF tuning needed in a digital system and drift and aging are non-existent in the numerical modulator. Finally the system allows very agile modulation without analog time constants or filters, thereby it is possible to approach theoretical levels better than an analog system.

Numerical modulation and digital generation of the RF allows a fully synchronous system to be built. There are a number of processes that need to run: pixel data read to be read from memory and fed to the modulators and the RF carrier needs to be generated and modulated. If the scanning is done by an acoustooptic or electrooptic deflector the data controlling the deflector needs to be fetched from memory, converted to an electric signal and fed to the deflector. For an acoustooptic deflector AOD, an RF chirp needs to be generated. Traditionally, the RF carriers were generated by asynchronous free-running oscillators. The same applicant has used a digitally synthesized RF chirp which has been synchronized with the data clock for the loading of frequency values to the chirp and the pixel data. The RF sent to the modulators has had a free-running crystal oscillator as local oscillator. With fast modulator rise times there is a possibility of creating a jitter in the rising and falling edges of the wave form used to modulate light beams due to the uncontrolled phase of the RF used by the AOM. Moving to a fully synchronous system removes this source of jitter.

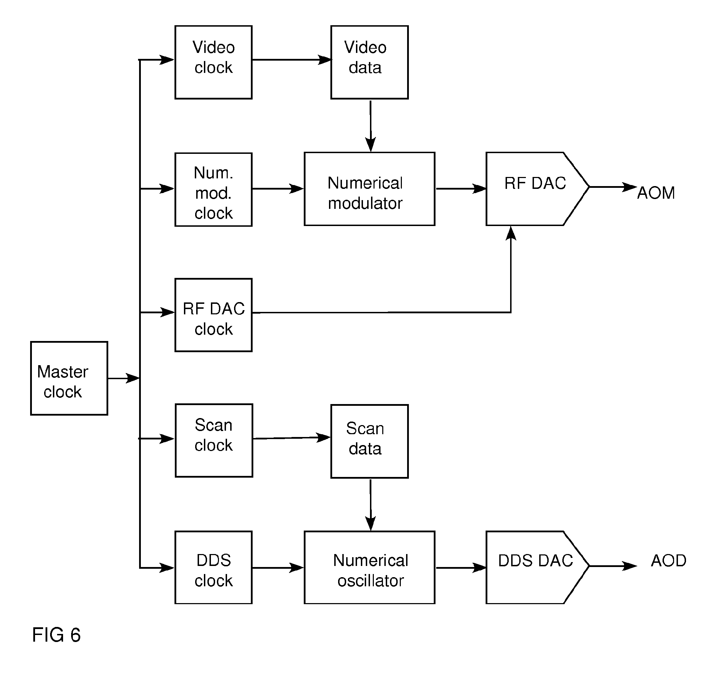

**FIG. 6** shows the clocks in a fully synchronous writer using acoustooptic modulation and scanning. There is a master clock which is the basis of all synchronisation. It may be one of the slowest clocks in the system, e.g. the pixel clock. From the master clock, clocks for other subsystems are generated by well known methods of clock multiplication. The pixel clock, here called the video clock, determines when each pixel is to be written. It may be 50 or 100 MHz. From it the DAC clock for the AOM RF is generated, typically 1.6 - 2.5 GHz. The FPGAs calculating the amplitude values run at an intermediate clock, e.g. 400 MHz. With the RF carrier 400 MHz and pixel clock 100 MHz there are exactly four RF periods in each pixel and the RF DAC may run at 1600 or 2400 MHz. We will show later that 4 samples per period gives a simple implementation of phase modulation, therefore 1600 MHz is a useful clock for the DAC.

The technology disclosed can be built with any of several fast DACs that are commercially avalable, e.g., AD9739A from Analog Devices. Similar devices are available from Texas Instruments, Philips and other companies. Suitable FPGAs are avalable from from several companies, e.g., Xilinx and Altera. An experimental system is being built with a experimental kit Kintex 325 from Xilinx.

**FIG. 6** also depicts generation of an RF chirp used by the AOD, applying similar direct digital synthesis principles. A single master clock drives both RF output to the AOM and DDS synthesis of RF for the AOD.

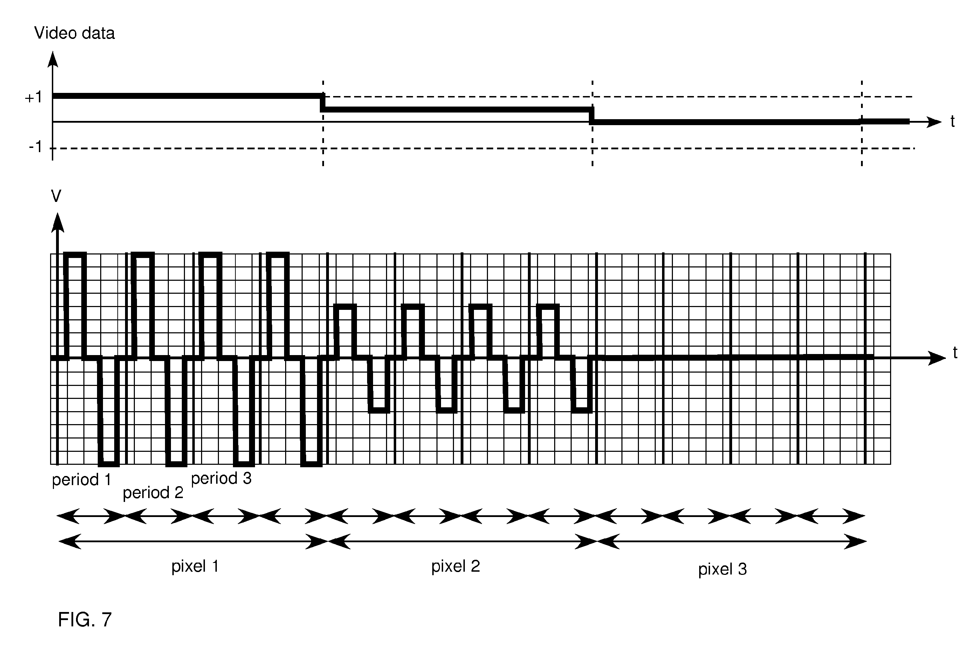

**FIGS. 7-11** show example video signals produced by complex modulation of samples used to produce an RF signal and then to drive an AOM transducer. Within pixels 1-3, the figures illustrate periods 1-4 of a complex RF signal. Multiple clock intervals and four sample points used to generate the RF signal fall within the illustrated periods.

**FIG. 7** shows an example fully synchronous system with the parameters above. The diagram shows three pixels, each with four RF periods, and each RF period sampled four times. The first pixel is fully on. The second is partially on, with the video data graphed at an intermediate value between 0 and +1. The third pixel is off or dark. In each RF period, there are four sample point marked with vertical lines. In the on pixel, the sample points have the values 0, +1, 0, and -1. In the gray pixel, the sample values are 0, +0.5, 0 and 0.5. In the dark pixel, all values are 0. This is a digitally generated RF voltage using amplitude modulation as in **FIGS.** 1C and 2A-D. The dissipated power varies between maximum in the first pixel and zero in the dark pixel. The RF waveform in **FIG. 7** has many harmonics, but they will dissappear in the filter in the RF amplifier and in the transducer and optical system.

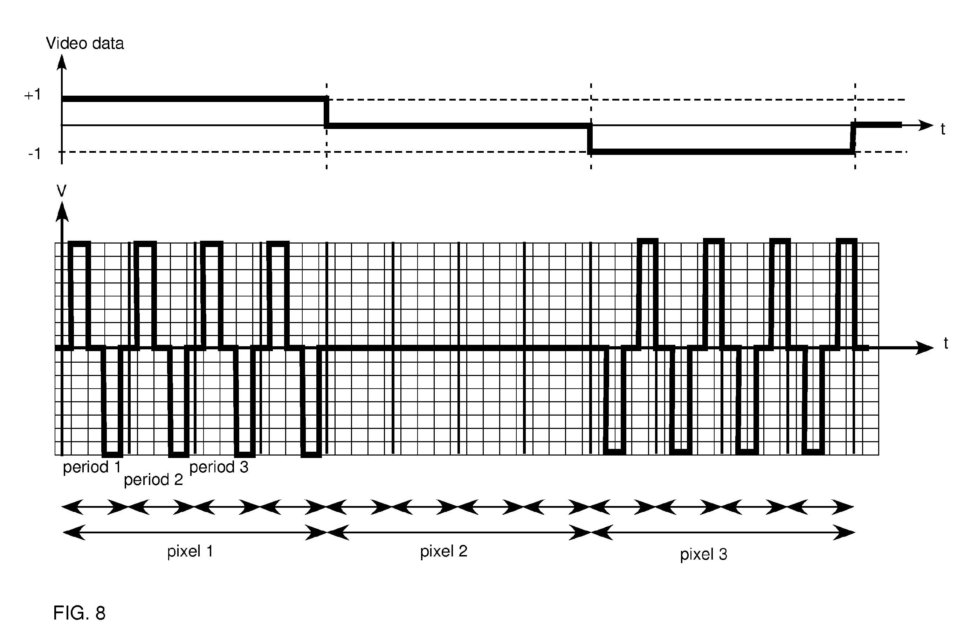

**FIG. 8** also shows three pixels. The first pixel is fully on, the second is dark and the third is fully on but with reversed phase. The video data goes between -1 and +1. The video controls the real part of the RF amplitude, the imaginary part is zero. This is the same numerical modulator, but modulating according to **FIGS. 1D** and **FIGS. 3A**-**E**.

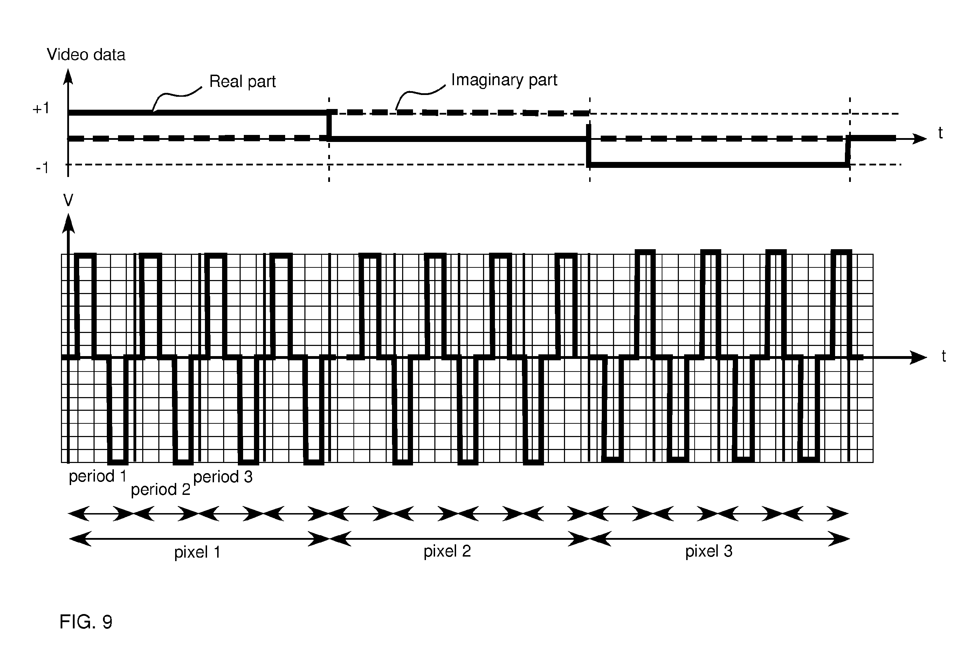

**FIG. 9** shows three example pixels with phase modulation. The first pixel has the amplitude (1 + 0j) (sample points 0, 1, 0, -1), the second has the amplitude (0 + 1j) (samples -1, 0, 1, 0) and the third has (-1 + 0j). Between pixels, the phase of the RF is delayed by 90 degrees. With four samples per period it is easy to do complex modulation, since the modulator is linear in amplitude. To generate the complex amplitude (a + bj) one can add a * (1 + 0j) and b * (0 + 1j) which is a times the first pixel and b times the second pixel. Therfore the sample points in (a + bj) are -b, a, b, -a. In this way arbitrary complex values can easily be generated using four samples per period.

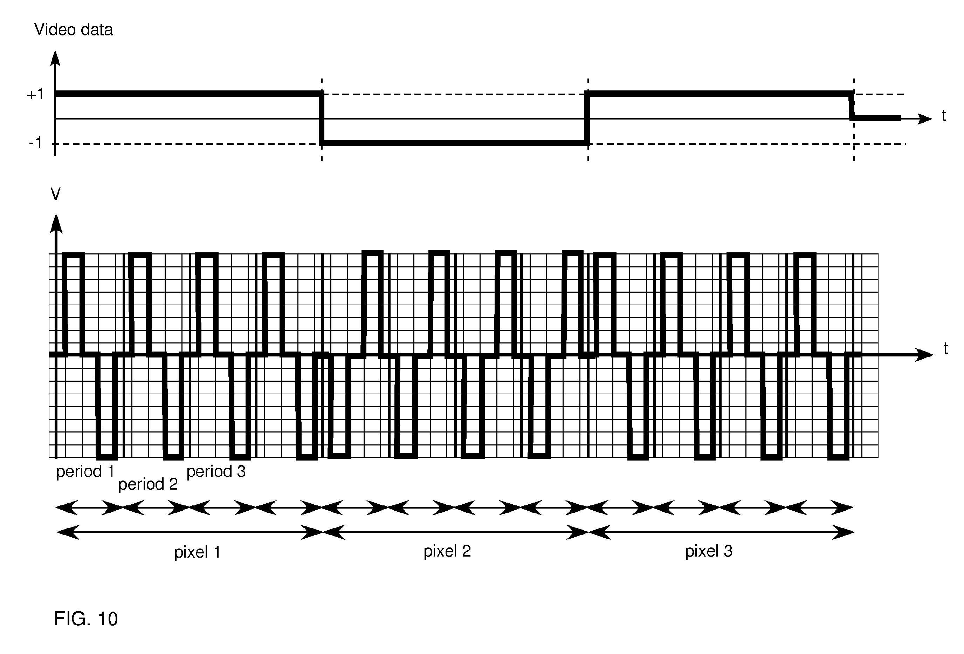

**FIG. 10** shows phase reversal between the pixels. The first pixel has phase 0, the second one 180 degrees, and the third 0 degrees. Depending on the optical resolution of the writing system, the system may write the pixels as white areas with dark lines in between or the beam may be extinguished by destructive interference. Note that even for resolutions at which the beam is extinguished, the RF power is constant at full power.

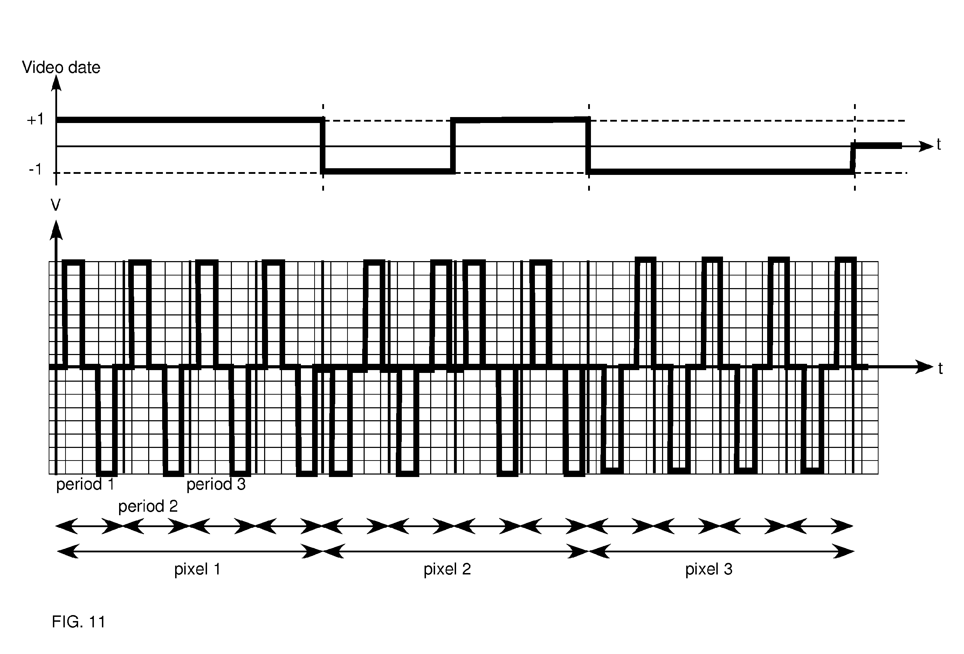

**FIG. 11** shows two on pixels with a black pixel in between. The second (middle) pixel is divided into two parts and the phase is reversed between the parts. The image is two bright areas with a dark area in between. Note that the RF power is constant, even though the light to the workpiece is extinguished in the middle pixel. This points to a method to keep the dissipated power in the modulator constant regardless of the written exposure. To write bright, turn the RF power on, set the phase to 0 or 180 degrees. To write dark, turn the RF power on, flip the phase between 0 and 180 rapidly. But what about gray?

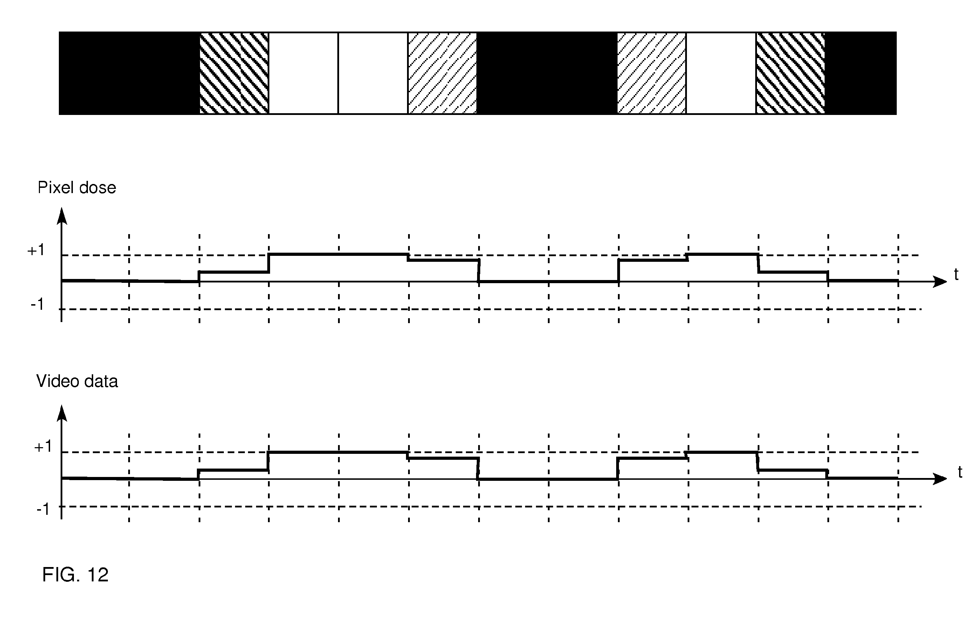

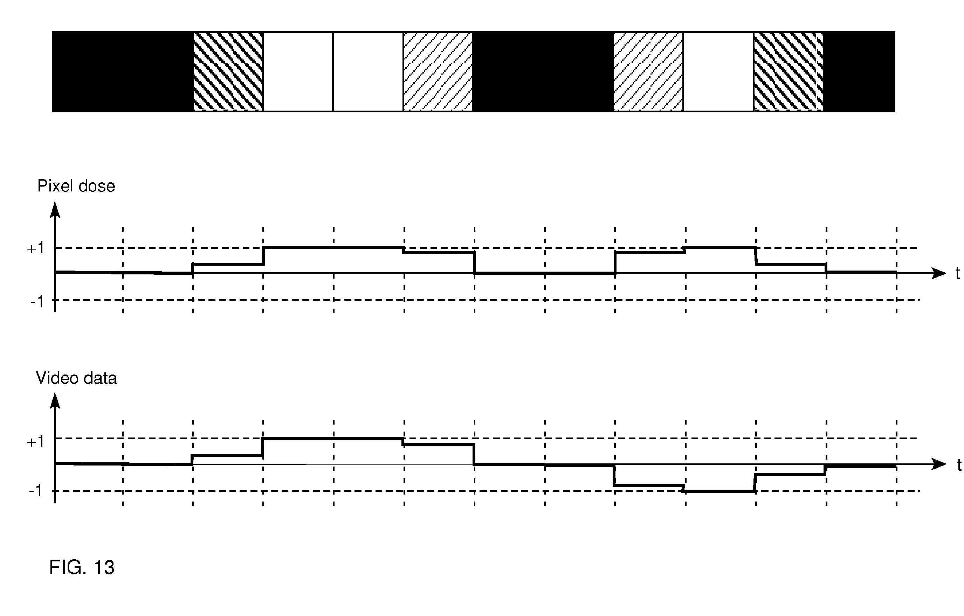

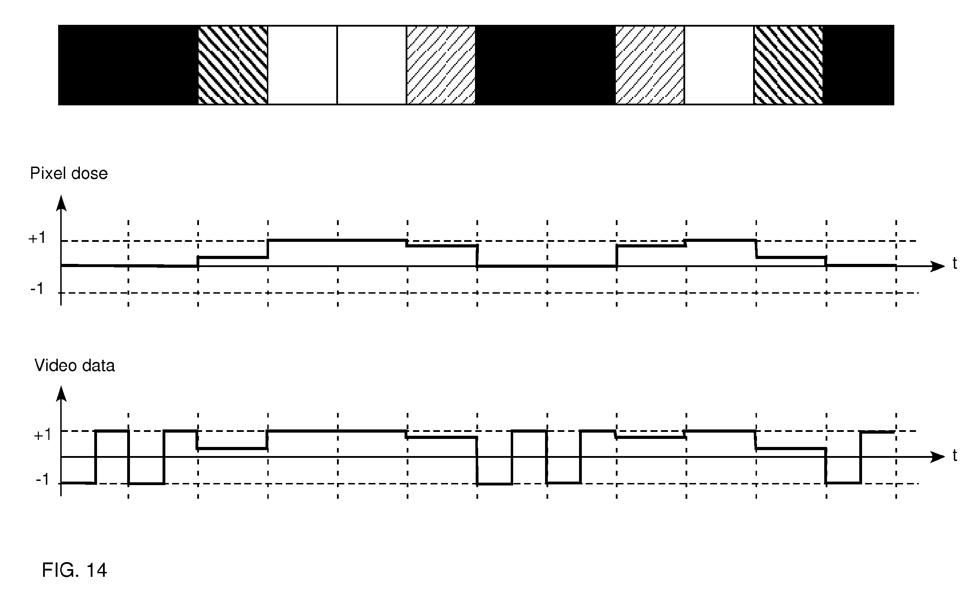

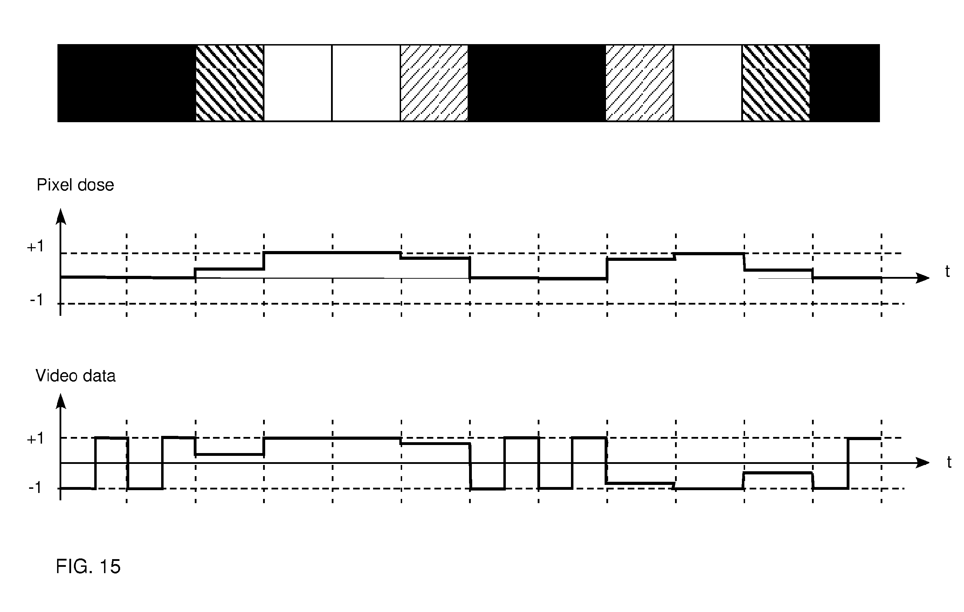

There are two possibilites for writing gray value pixels. The first method to write gray is to have a constant phase and set the RF power to an intermediate value as shown in **FIGS. 12****,** **13****,** **14** and **15**. In **FIG. 12** amplitude modulation is used, as illustrated in **FIG. 1C****.** **FIG. 13** shows the writing scheme of **FIG. 1D**, with phase shifting along the field, with intermediate power in the gray areas and zero. In **FIG. 14** the dark pixels are made dark at full RF power by flipping the phase rapidly. It is shown that the phase is flipped inside the pixel, but the figure is slightly misleading. The figures in real-life patterns are typically larger compared to the pixel size and dark areas typically extend several dark pixels. It is therefore possible to reverse the phase between full pixels, at least with some combinations of optical parameters. The gray areas in Figure 14 have constant phase and reduced RF power. Since there are fewer gray than bright or dark pixels this leads to a reduced variation in the RF power compared to **FIGS. 12** and **13**, although there is still some variation. **FIG. 15** uses reversed phases between bright areas as in **FIG. 1D**, but with constant phase in gray pixels.

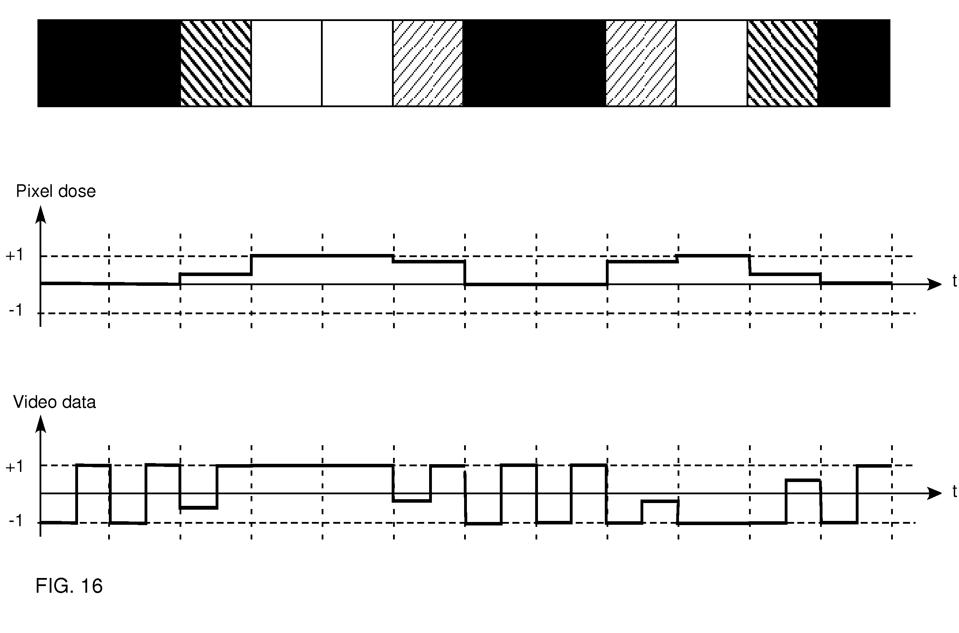

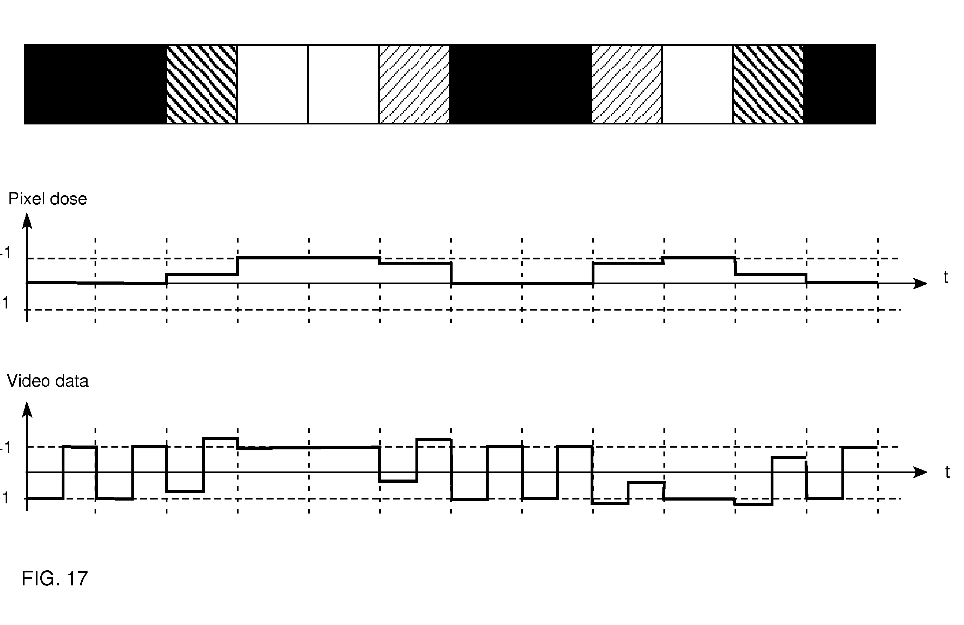

In **FIGs. 16** and **17** the gray pixels are divided into two parts and the amplitudes are calculated to give the desired pixel exposure dose and as constant RF power as practical. In **FIG. 16** the maximum amplitude is +1 or -1 and the other part of the pixel has the amplitude (phase 0 or 180 depending on what is necessary) which gives the correct exposure dose. With this limitation the RF power variation is about half of what it is with constant phase and amplitude in the gray pixels. In **FIG. 17** the limitation the the range -1 to +1 has been lifted. In this case it is possible to run constant average power in every pixel and satisfy the dose requirement. One of the halves of the pixel often gets a slightly higher RF amplitude than +1 or -1 and the other is also increased to pull the exposure dose down. For each pixel there is a simple system of two equations to solve, which may be done in an FPGAs.

Keeping the RF power in the modulator more constant helps to reduce thermal drift in the optical axis which comes from varying temperature gradients in the modulator. A large protion of the RF is dissipated by the transducer which is located only about one millimeter from the laser beam. When the RF power varies the temperature gradient across the laer beam changes with a time constant of a couple of seconds and affects the pointing stability of the beam. To keep the RF power more constant will therefore make the system more stable and easier to calibrate.

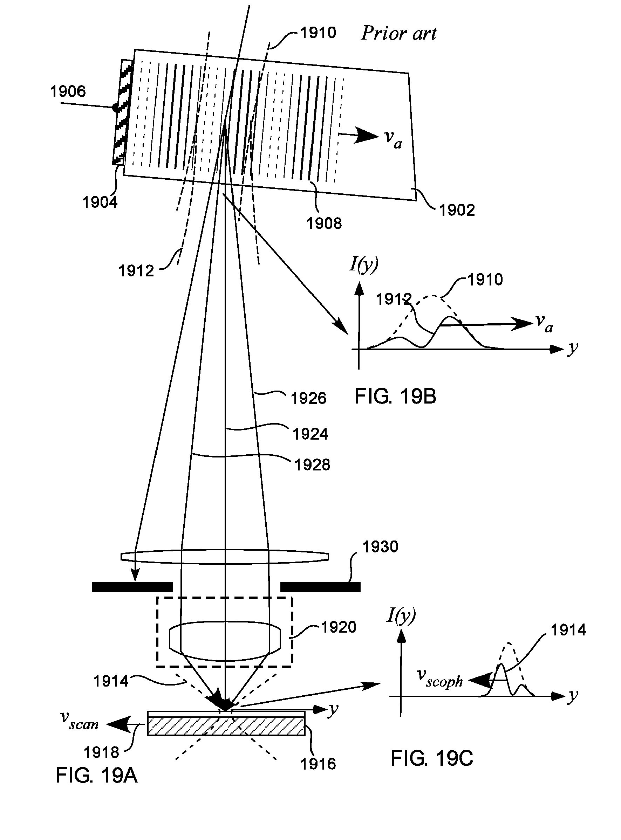

The resolution can be strongly improved with essentially unchanged optics by using modulation with reversed phases between adjacent exposed stretches of pixels along the one-dimensional optical field. This will be explained in relation to the acoustooptically modulated laser scanner in FIG. 19A. It may be noted that an acoustooptically modulated laser scanner may have for each beam a one-dimensional optical field and the fields from two beams may not interfere. Many of the properties of the technology disclosed stem from limiting its application to a one-dimensional optical field, in particular the simple rasterizing algorithm and the absence of phase conflicts. Phase-shifting in 2D optical fields is known in the art, but the rasterization is much more complex and may for many patterns not even be solvable without modification of the input pattern. The heart of the scanner is the acoustooptic crystal 1902. A transducer 1904 driven by an RF signal 1906 excites a mechanical ultrasound wave 1908, which modulates the density of the crystal and thereby creates a 3D phase grating in it. The ultrasound grating diffracts an incident laser beam 1910 and causes most of the energy to exit the crystal as a diffracted beam 1912 which is projected to a small beam waist 1914 on the workpiece 1916. If the RF 1906 is turned down, the beam 1914 at the workpiece is also turned down, i.e. it is modulated by the RF. The thin and thick lines in the figure show the ultrasound grating being modulated. To make this into a one-dimensional scanner the spot has to be scanned over the surface of the workpiece 1916. The scanning is indicated by the arrow 1918, although practical implementations typically use fast acoustooptic or mechanical scanners symbolically shown by the box 1920. The scanning velocity vscan is typically rather high, e.g. 10-50 m/s.

The naive picture of the acoustooptic modulator is that the laser beam is focused to a pinpoint in the modulator and the entire beam is modulated instantaneously. In reality, the beam has a finite width 1910, 1912 in the modulator and across the beam there is a variation of the ultrasound grating. This is shown in the inset FIG. 19B. The dashed line shows the envelope of the incident beam 1910 and the solid line the diffracted beam 1912, point by point modulated by the ultrasound grating. The ultrasound grating with its modulation is transported through the crystal with the acoustic velocity va and the diffraction across the beam changes rapidly.

The instantaneous cross-section is projected on the workpiece as the inset FIG. 19C shows. Everything is shrunk with the demagnification M of the projection system, both the beam size and the velocity of the variations across the beam, called the scophony velocity v_{scoph}. If the beam is 200 microns in the modulator and the beam on the workpiece is 1 micron, the demagnification may be 0.005. The acoustic velocity is approximately 5000 m/s and the scophony velocity is 0.005*5000 = 25 m/s. With a pixel size of 0.5 microns along the scan line and 50 Mpixels/second the scan speed is also 25 m/s. It is thus shown that with reasonable parameters the pattern moves through the beam with the same velocity that the beam scans the workpiece. Therefore, the pattern is essentially standing still on the workpiece and the resolution is not determined by the beam size 1 micron, but by the optical resolution of the optical which may be much higher. This is called scophony and we may call the matching of vscan and v_{scoph} the scophony condition. At the scophony condition, the modulator acts as a mask (albeit one flying past at high speed) and the imaging in the scanning direction is essentially identical to partial coherent projection with the beam envelope playing the role of the coherence function.

What is particularly interesting is that the mask is the RF driving signal, the magnitude and phase of which can be controlled electronically. This is shown in FIGs. 2 and 3. FIG. 2 shows a conventional modulation system. The RF signal driving the modulator is derived from a carrier wave V_{LO} from a local oscillator in FIG. 2B. To create the conventional ultrasound grating shown in FIG. 2B the carrier is multiplied by a video signal in an RF modulator, typically a voltage A_{mod} in the range 0 - 1 V such that 0 V gives no RF and 1V gives maximum RF level. The result is V_{mod} in FIG. 2B which has a varying envelope, but a constant phase everywhere.

The RF voltage drives the transducer 1904 and is converted to a mechanical propagating wave. In principle, the transducer converts a time-dependent voltage V_{mod}(t) to a position-dependent stress in the crystal □(y) (Greek sigma) and the phase and magnitude of the RF is translated to phase and magnitude of the mechanical wave. The stress creates an index variation in the crystal and a phase grating. In FIG. 19A, the incident beam has an angle to the direction of the diffracted beam and the angle gives an optical amplitude a₀ rapidly varying phase across the crystal. The phase of the inclined beam and the phase of the mechanical wave mix non-linearly in the crystal, effectively undoing the action of the RF modulator, and the result is that the diffracted beam gets the optical phase and magnitude that was input as video to the RF modulator. The resulting exposure dose I+1(y) follows the video A_{mod} although with a non-linear transfer function. The index +1 indicates that it is the first order diffracted beam.

**FIG. 3** is very similar, but results in a twice finer pitch in the exposure I+1. One difference is that the video A_{mod} goes to negative amplitudes. The result is that the modulated RF changes phase at each minimum of the envelope. This is also seen in the wave pattern in FIG. 3A. It seems like a trivial change, but a different type of modulator is needed for multiplication between the carrier and a video which changes sign.

**FIG. 2C** shows the power spectrum of V_{mod} for a conventional system. Like any amplitude modulated signal it has sidebands 200, 202 related to the modulation, but approximately half of the power is at the carrier frequency 204. The stress □ has the same spectrum and this spectrum is transferred to the laser beam during the diffraction. The carrier 204 becomes the +1 order diffracted beam 1924 travelling down along the optical axis of the projection optics in FIG. 19A and the sidebands 200, 202 generate side beams 1926, 1928. The aperture stop 1930 in FIG. 19A can be represented by a blocking filter with edges 206 in FIG. 2C. If the sidebands 200, 202 (side beams 1926, 1928) fall outside the open part of the blocking filter 206 (aperture 1930) the modulation is lost and the pattern on the workpiece disappears. The higher the modulation frequency A_{mod}, the further apart the sidebands and above a cut-off frequency the pattern becomes just a middle-gray uniform exposure. This is the mechanism by which the numerical aperture (NA) of the projection optics limits the resolution when the scophony condition is fulfilled.

The same spectral analysis applies to the technology disclosed, FIG. 3C. The difference is that the different type of modulation removes the carrier. The frequency of A_{mod} is the same as in FIG. 2C and has the same cut-off frequency. But A_{mod} is transferred as an amplitude to the workpiece and in the non-linear exposure process both peaks and valleys of the amplitude expose the light-sensitive surface and an effective frequency doubling (or pitch halving) occurs between the amplitude and the exposure. The same effect does not occur in the conventional system since the values of the amplitude are zero and therefore cause no exposure.

FIGs. 2D and 3D show the difference in the complex plane. The arrows 220, 320 show the optical amplitude as a phasor for a white pixel at the workpiece. And the oblong area 222, 322 show where the tip of the phasor may end up during modulation. In the conventional system pixels are allowed to take any value on the positive part of the real axis 222, while in the technology disclosed points along the entire real axis may be used. FIGs. 2D and 3D represent efficient modulation schemes and pixels with a non-zero imaginary part that may be used, but are generally less efficient and may create aberrations in the optical image. A non-zero imaginary part in the conventional system is defined by Re(a) larger or approximately equal to zero, whereas the technology disclosed is defined by Re(a) being any number (typically normalized to the range +/-1). Approximately equal to zero can be taken to mean that the magnitude of the phasor is less than 0.25. Methods to realize such modulation will be described below.

The diagrams should be interpreted to apply locally in small neighborhoods, where the phase of a white pixel has been referenced to be 0. In this way, slow variations in the phase of the light beam across the surface are removed from the analysis.

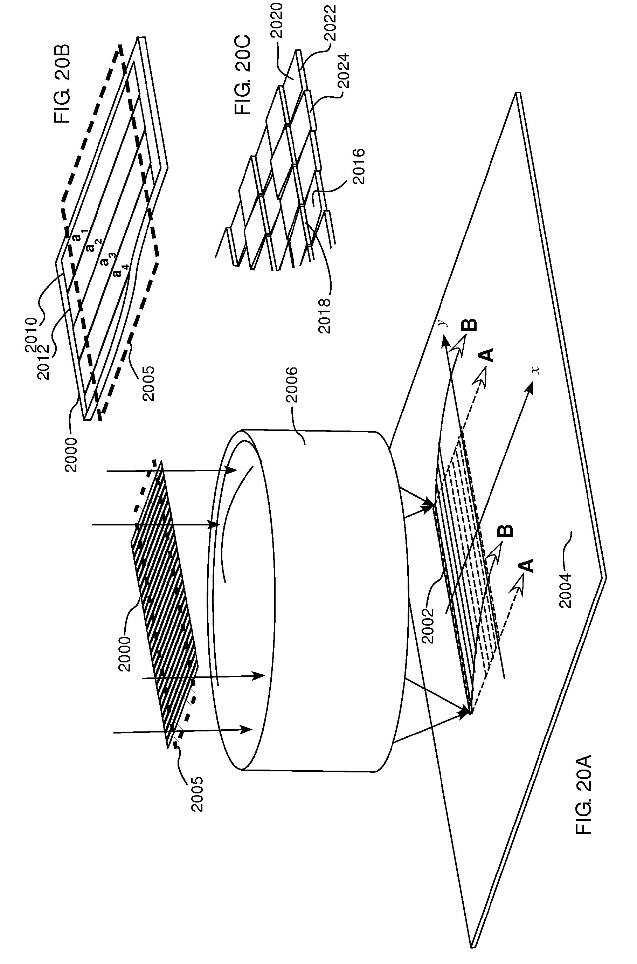

FIG. 20A shows a known architecture (Micronic-Mydata, Sweden) using a one-dimensional SLM 700 to expose a one-dimensional field 2002. The field is scanned over the surface of the workpiece, either in a linear motion A or a non-linear motion B, thereby building an exposed pattern. For power handling, the SLM may have a finite size in the x direction and be illuminated over a substantial area 2008 and still write a one-dimensional field 2002 through the use of anamorphic projection optics 2006. The illumination is partially coherent along the SLM and fully coherent across it.

In FIG. 20B such an extended ("wide") SLM is shown to have pixel areas 2010, 2012 which can modulate the amplitude of the optical beam with the amplitudes a1, a2, a3, ... The amplitudes may be mainly positive, i.e. Re(a) larger than -0.25 (conventional) or have any value in the range -1.00 to 1.00 (novel). The SLM may be implemented in many ways, e.g. as an LCD device (reflective or transmissive) or a reflective micro mirror device. In the case of a micro mirror device, each pixel area may be built from many smaller mirrors which move together or independently and where the mirrors are controlled to produce pixels on the workpiece with the desired phase and magnitude. FIG. 20C shows an example: tilting mirrors 2016 with a phase step 2018 of a quarter wavelength (half a wavelength delay of the optical phase in reflection) arranged in rows 2022, 2024. This mirror type has been described in a patent by U. Ljungblad US7110159 and modulates the light from complex amplitude (-1 + 0j) to (+1 + 0j) along the real axis. Other complex-modulating mirrors and mirror clusters can be found in patent and scientific literature. Each pixel area 2010, 2012 in FIG. 20B corresponds to rows of mirrors in FIG. 20C 2022, 2024. The mirrors in one row are actuated in unison.

The explanation of the resolution enhancement in y with this modulator follows the acoustooptic one closely, except that the modulation is done by mirrors, not by ultrasound waves, and there is no scophony involved.

An interesting property of both types of modulation is that the difference between the conventional and the novel system can be controlled by software. Even if the conventional systems are modified to allow the novel modulation, they will continue to write as conventional systems when driven with conventionally rasterized data. One aspect of the technology is that the rasterization of the data takes advantage of the added modulation flexibility. By turning on or off the high-resolution rasterization, a writer can switch between two modes: one with approximately isotropic x-y properties and one with twice the resolution (half the pitch) in y versus the unchanged x direction.

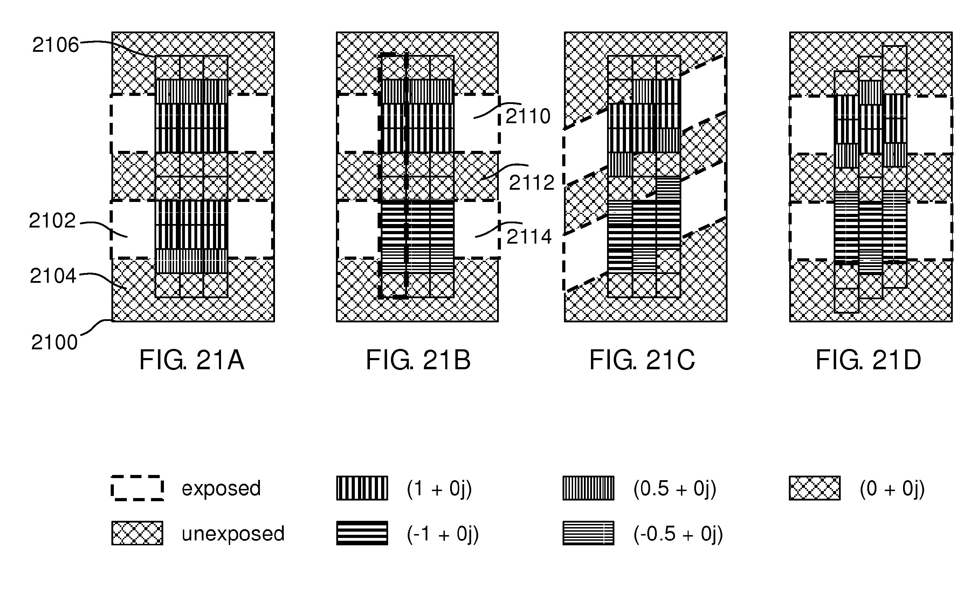

FIG. 21A shows a pattern 2100 having exposed 2102 and unexposed 2104 areas ( a binary pattern) being conventionally rasterized to a pixel grid 2106. The legend below FIGs. 21A-D shows the meaning of the hatching. Pixels which fall fully inside an unexposed area are rendered (rasterized) dark, i.e. with complex amplitude (0 + 0j). Pixels falling fully within exposed areas are rendered white (1 + 0j). Pixels falling partly inside an exposed area are rendered with an amplitude (0.xx + 0j) where 0.xx is a number between 0 and 1. The transfer function from overlap to pixel amplitude or pixel intensity is empirically calibrated, stored and applied to the data during rendering (rasterization).

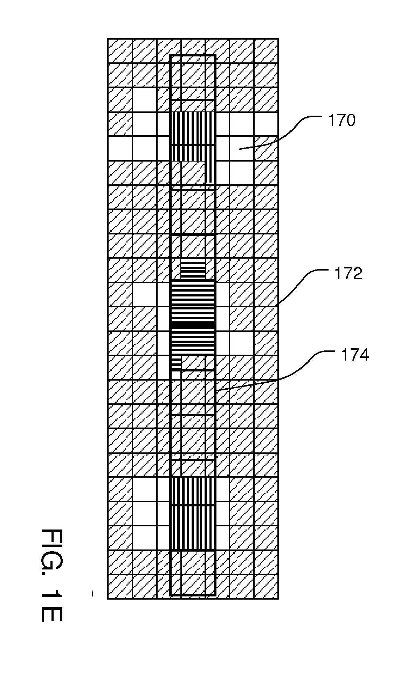

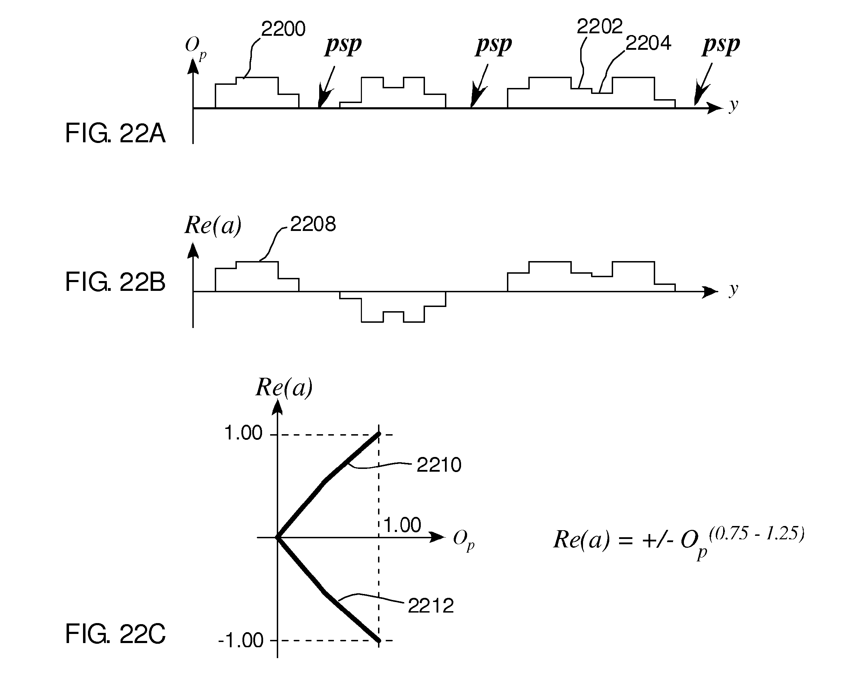

In FIG. 21B the same pattern is rendered using the technology disclosed. The top exposed area 2110 is rendered as in FIG 21A, but on the other side of the dark area 2112 the next exposed area 2114 is rendered with the opposite phase, i.e. from complex (0 + 0j) to (-1 + 0j) instead of from (0. + 0j) to (1 + 0j). Since each one-dimensional field is written at a different time from the next one, there is absolutely no coherence between pixels in the x (crosswise) direction and phase relations between pixels in x have no importance. This has two important consequences: 1) each field can be rendered independently from its neighbours, and 2) there are no phase conflicts since phase conflicts come from forks in the pattern and a one-dimensional pattern has no forks. If each field is rendered independently from other fields, the situations in FIGs. 21C and 21D are automatically handled well. FIG. 1D shows in detail how the overlap between pixel area and figure in the data may be computed. The input data may be given as vectors, either as a polygon or as a collection of loose line elements. Where the lines cross through a pixel the overlap is computed. There are several methods known in the literature, e.g. super sampling, table lookup, and direct analytical evaluation. In some pixels there may be a corner point or the overlap is defined by more than one line element. These cases may be evaluated by super sampling, they may be evaluated analytically, or combinations of the two methods can be used. It may be practical in some situations to pre-render 170 the pattern on a first grid 172 and rerender it again 174 for grid of the disclosed writer. FIG. 1E shows such a situation where the pattern is defined as a binary raster grid (grayscale is analogous). The overlap is calculated from the pixel values in the input pattern. One method is to rasterize the pre-rendered pixel pattern as shown in FIG. 1E, i.e. the value each pre-rendered pixel is added to one of the writing pixels, or divided between several of the writing pixels. A second method is to analyze a small cluster of pre-rendered pixels and calculate a small patch of binary vector pattern giving the pre-rendered pixel pattern, e.g. an edge or a corner, and re-render the vector pattern pitch. The advantage is that for most patterns there is no quality loss from rendering more than once. FIG.3e shows how different overlaps between exposed areas and pixel areas map onto the pixel amplitude a. The input vector pattern is assumed to be binary containing fully unexposed and fully exposed areas. However, to get the resolution increase described above, two exposed areas with a narrow dark area between them needs to have phases that differ by approximately 180 degrees, or at least more than 90 degrees. Typically, some exposed areas will have a phase defined to be 0 degrees (complex amplitude (1 + 0j). A neighbor exposed area separated by an unexposed area then needs to have the phase 180 degrees (i.e. complex amplitude -1 + 0j) or less optimal a phase between 90 and 270 degrees. Phase 0 is shown with vertical hatch lines and phase 180 with horizontal lines. The principle is that along the one-dimensional field exposed stretches 190, 192, 194 are alternatingly assigned phase 0 or phase 180. In FIG. 1D the input areas have been assigned alternating phases, shown as vertical or horizontal hatch lines. The overlap is then calculated for each pixel. But when the overlap is translated to complex amplitude, FIG. 3e the different phases (hatch pattern) give different signs for the real part of the amplitude, while different overlap values give different magnitudes. In FIG. 22 an algorithm for rendering is shown. First, FIG. 22A shows conventional rendering with resolution high enough for the enhanced resolution. The graph 2200 shows pixel values 2202, 2204 (essentially overlap values) along the y axis of a single field. The sequence of pixel values is examined for dark stretches satisfying a dark condition, such as being below a certain threshold ( e.g. 0.25) value for two consecutive pixels. When the condition is fulfilled, the place is marked as a phase switch point (psp). The data is then processed and at each phase switch point the data is toggled between the positive branch 2210 and the negative branch 2212 in FIG. 22C, producing the graph 2208 in FIG. 22B. The algorithm is so simple and robust that it can be implemented as a filter on ready-rendered data, e.g. in an FPGA loading data into the writing system.

FIG. 22C shows the correspondence between the overlap O and the real part of the pixel amplitude at the workpiece. Each branch is essentially a straight line with a small allowance (exponent between 0.75 and 1.25) for empirical calibration and higher order effects.

The pixel amplitude values have an approximate linear relation to the placement of edges (or generally to many optical effects) in the pattern and the data in FIG. 22C is a suitable representation for bitmap operations, such as feature shrinkage or dilation or edge sharpening. An example of edge sharpening is the convolution with a kernel with some derivative power, e.g. (-0.15, -0.15, 1.6, -0.15, -0.15). After such processing, the data needs to be conditioned for the actual modulators by application of stored micromechanical SLM calibration or saturation curves for the interaction in the acoustooptic modulator.

### Advantageous Effects

What is described above is the addition of a second writing mode with approximately twice the resolution of the conventional mode as used in one-dimensional pattern generators and laser writers using both acoustooptic and SLM modulators. The resolution improvement is only achieved in one direction and is therefore mostly applicable to special patterns, such as wire grids, transparent meshes, and transistors. The new writing mode can be switched on or off by software, and does therefore not hamper the normal use of the writers.

### Further Discussion

The RF signal needed to drive the acoustooptic can be created in several ways. FIG. 4 shows one possibility using a commercial quadrature modulator 410 (similar circuits are available from Analog Devices, Linear Technology, Mini-Circuits, Maxim, and others). To the right in the figure is a simplified writer with an incoming laser beam 402, a modulator 400 and a diffracted beam 404 focused by the optics 408 onto the workpiece 406. The carrier 412 is fed to the LO (local oscillator) input of the modulator 410. The digital vector data 414 is rasterized to digital pixel data 416 in a rasterizer 418 and DA converted 420 to an analog video signal 422 and its inverse 424, both fed to the real-axis input of the modulator 410. The imaginary-axis inputs are not used, and are shown as grounded 425. It is also possible to apply data to the imaginary input, e.g. to correct for phase errors. Inside the modulator the carrier is phase split 426 into quadrature signals and the video inputs and carrier are fed to balanced mixers, and the signals from all modulators are added 430. The result is the real-axis complex modulated RF 432 shown in FIG. 3 which is amplified 434 to a level suitable for the modulator 400 e.g. 1, 2, or 5 watts. For a multibeam writer everything except the local oscillator LO is multiplied by the number of beams.

The theoretical limiting resolution (line width) in the y direction will be 0.25 * wavelength/NA and a practical resolution 10 - 50% higher. For an example large-area writer with NA = 0.7 and 413 nm wavelength the limiting resolution may be 0.15 microns and a practical limit 0.17 -0.22 micron. For an example reticle writer with NA 0.86 and wavelength 413 nm the limiting resolution may be 0.12 microns and practical 0.13 - 0.18. For the extreme case of NA 1.33 (water immersion) and wavelength 266 nm the limit may be 51 nm and practical resolution 56 - 77 nm. At the other end of the scale a direct-writer with NA=0.15 and a wavelength of 355 nm will have a theoretical resolution of 0.58 micron and a practical resolution of 0.65 - 0.90 microns.

All these numbers are for dense lines and spaces, isolated lines may be made more narrow by under- or overexposure. In a dual-mode system the design cannot be optimized for the resolution of the high-resolution mode only. The scophony condition and the pixel size may have to be compromised for throughput in the normal mode. This may lead to some loss of contrast for fine-pitch patterns and an effective loss of some resolution. The exact loss can only be determined during the detailed design with the totality of requirements available.

### Various Implementations

A first mode of carrying out the technology disclosed is to add a balanced mixer to the RF modulator of an acoustooptically modulated scanner, adjusting the scanning for the scophonic condition and rasterize the data following the guidelines given in this specification.

A second mode of carrying out the technology disclosed is to configure a one-dimensional SLM in a pattern generator or direct writer to give phase modulation to the light and to rasterize the input data according to the guidelines given in this specification.

A third mode is to use either of the two modes given above and write features with high resolution in a first direction, physically rotate the workpiece, align it to the first pattern (possibly using methods from application on aligning) and write a second set of features with high resolution in a second direction, typically perpendicular to the first direction.

A fourth mode of operation is to write a set of narrow lines with the methods put forward in this specification and then multiply the pitch by chemical methods, in particular
by directed self-assembly.

A fifth mode of carrying out the technology disclosed is to rasterized the input pattern to an area-sampled bitmap, then extract a single column of pixel values, finding phase switch points where the illumination is intended to be low, and switch the phase between 0 and 180 degrees at phase switch points.

### Industrial Applicability

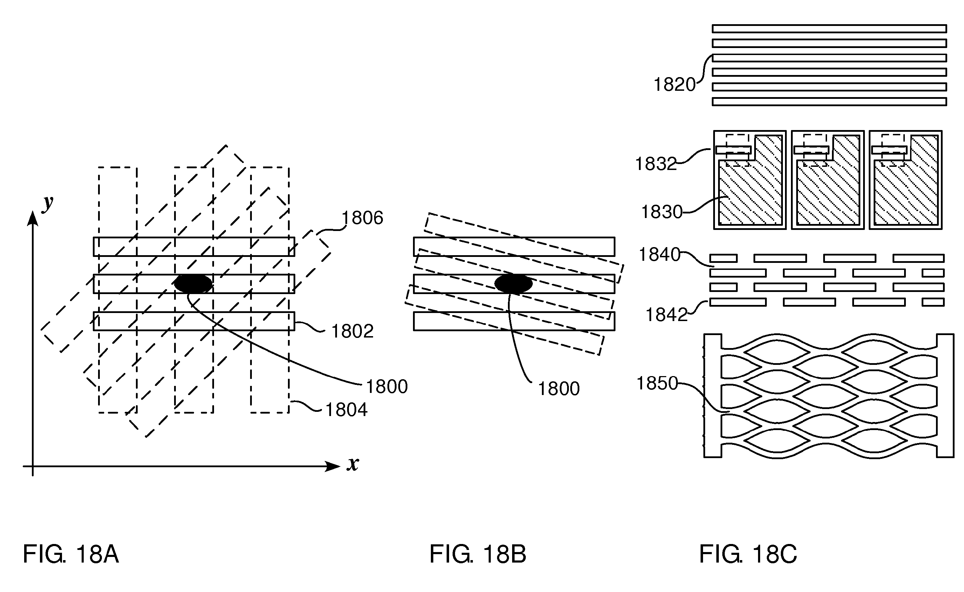

The technology disclosed is enabling for a range of patterns such as those shown in FIG. 18C. By using double pass writing with a rotation of the workpiece between the passes more general patterns than shown in FIG. 18C can be written. The resolution can be further refined by known processes. It is known to write a line or dot pattern with a pattern generator and multiply the pitch by a number of methods: The first method is writing multiple interlaced sets of thin lines, thereby creating a pitch which in itself is too small to be resolved by the pattern generator. The second is to create two lines out of every line during processing by chemically building a wall around each written feature and use the wall as two new features. The third known method is to use so called directed self-assembly, see US7790350B2. The patent, which also contains
references to other publications on self-assembly, describes a class of materials, diblock copolymers, where the oblong molecules have ends with different surface energy. One end of the molecule may be based on PPMA and the other on polystyrene. When a mixture of these molecules are dispersed as a film on a surface they spontaneously form parallel lamellae (or columnar micelles depending on the chemical formula). The lamellae form parallel lines in the short range and chaotic patterns in the long range. The result may be similar to a fingerprint with parallel lines in an irregular pattern. It is possible to control the long-range order by lithographic features, e.g. parallel lines, and make the diblock co-polymer form thin parallel lines which also exhibit near-perfect long-range order. If the co-polymer wants to form lines with a pitch of 100 nm and it is dispersed in trenches that are 300 nm they divide the 300 nm trench into three narrow trenches. A line or trench can thus be divided by an integer number such as 2, 3, 4, 5, etc. All three methods described in scientific literature can divide a written trench into two, three or many trenches. The methods in this specification can be used to create for example a line pattern with pitch 0.4 microns and divided by two to 0.2 microns or by four to 0.1 micron. Writing in a large-area pattern generator having an effective NA around 0.5 may create regular lines with 0.5 micron pitch using the methods set forth in this specification. Dividing the pitch of these lines by four by chemical methods (e.g. by self-assembly) will give a regular line pattern with 0.125 micron pitch or 63 nanometer lines and spaces. Higher NA and/or division by a larger integer may give even smaller lines. This may be an industrially viable method to create a pattern of lines 63 nm or smaller parallel lines, uniform over the area of a window or a TV screen. Lines around 50 nm, which are sub-optical in the sense that they are not resolved by visible light but act on light through an effective index tensor, may be used as polarization-modifying structures, e.g. wire-grid polarisers or retarders, or they can have nano-physical properties that are desirable, e.g. self-cleaning or material properties different from the bulk. Self-assembly linewidth depend on the molecules used and may range from 5 to 100 nanometers. Typically the lines fall in the range 10 to 50 nm in width. To direct their assembly primary flines are needed, which are at most a few times larger. If the dividing integer is too large, e. g. 20, it may snap between 19, 20, and 21 depending on local errors in the guiding structures. Since this specification teaches methods to
make optical systems produce smaller features, there are many cases where the proposed technology will be enabling for self-assembly, in particular over large surfaces. There may be other methods to produce large devices with structures of the order of 50 nm or smaller, e.g. nano-imprinting where a template is replicated, but the problem of making the template remains. Such a template can be made with the methods described in this specification, i.e. by optical lithography using phase control in a one-dimensional field, to provide guiding structures for a subsequent self-assembly step which creates structures that may range from 63 nanometers down to about 10 nanometers. The invention is defined by the claims.

## Claims

1. A method of providing a synchronized laser scanning system by simplifying operation of an acoustooptical modulator, abbreviated AOM, used to modulate a laser beam and improving phase control of the laser beam, including:
digitally computing sample points of a wave form with wave form amplitude modulation and phase control that represent image pattern data;
providing a digital-to-analog converter, abbreviated DAC, for converting the digital wave form sample points to an analog radio frequency, abbreviated RF, signal, wherein the analog RF signal has a frequency that is an integer multiple of the image pattern data frequency; and
applying the analog RF signal to an AOM transducer to modulate a laser beam and create an image.

2. The method of claim 1, wherein the image pattern data is output at a frequency in a range of 50 MHz to 100 MHz.

3. The method of claim 1, further including alternating between positive and negative amplitudes between successive output pixels of the image pattern data;
wherein destructive interference between the positive and negative amplitudes of the successive output pixels produces a dark area between white areas of the successive output pixels.

4. The method of claim 1, further including using multiple FPGAs to produce multiplexed sample points of the wave form.

5. The method of claim 1, wherein an integer number of sample points are computed per cycle of the digital wave form.

6. The method of claim 1, wherein four sample points are computed per cycle of the digital wave form.

7. The method of claim 1, wherein the DAC is clocked an integer multiple of a frequency of the digital wave form.

8. The method of claim 1, wherein the wavelength of the digital wave form is an integer multiple of available phase control shifting of the digital wave form.

9. The method of claim 1, wherein the phase control shifting shifts the digital wave form by multiples of 90 degrees relative phase.

10. The method of claim 1, further including modulating the wave form to extinguish the laser beam by destructive interference across a crystal of the AOM.

11. The method of claim 1, further including reducing output RF power variation to one half the power variation resulting from using constant phase and amplitude to produce gray pixels.

12. The method of claim 1, further including alternating between positive and negative amplitudes within an output pixel of the image pattern data.

13. The method of claim 12, further including essentially extinguishing the laser beam by destructive interference by alternating between positive and negative amplitudes within an output pixel of the image pattern data.

14. The method of claim 12, further including essentially extinguishing the laser beam by destructive interference by alternating between positive and negative amplitudes in successive output pixels of the image pattern data.

15. The method of claim 12, further including gray scaling the laser beam by destructive interference by alternating between positive and negative amplitudes within an output pixel of the image pattern data.

16. The method of claim 15, further including maintaining an essentially constant RF power when alternating between the positive and negative amplitudes, relative to RF power applied when generating a white pixel of the laser beam.

17. The method of claim 1, further including directing the laser beam through an acoustooptical deflector wherein the acoustooptical deflector has a chirp that is digitally synthesized and synchronized to a clock used to generate the digital wave form.

18. The method of any of claims 1-17, further including using said method for writing fine pitch patterns in an optical writer having a one-dimensional optical field with a lengthwise and crosswise direction that scans in the crosswise direction, the method including the actions of:
receiving a pattern in which fine pitch lines are constrained to run within 30 degrees of parallel to the crosswise direction of the optical field, wherein the one-dimensional optical field is partially coherent in the lengthwise direction;
rasterizing a pattern such that transitions in the pattern across the lengthwise direction from light to dark cause a reversal in a sign of the real part of an amplitude of pixel data generated by the rasterization, and
modulating light in the one-dimensional optical field to a complex amplitude where the real part of the complex amplitude follows the sign of the pixel data, whereby line-space patterns down to about 0.25 * wavelength/NA can be resolved.

19. The method of claim 18, wherein the fine pitch lines are further constrained to run within 15 degrees of parallel to the crosswise direction.

20. The method of claim 18, extended to dual mode writing, further including:
providing a second writing mode where the rasterizer renders to pixel data with only non-negative real parts of the amplitude; and
switching between the modes by changing the algorithm used by the rasterizer, whereby the new high resolution mode is added to a system without sacrificing the flexibility and image quality of the conventional writing.

21. The method of claim 18, further including using said method for creating a partially coherent writing condition in a raster-scanning laser writer, including:
providing an acoustooptic modulator having an acoustic velocity;
using projection optics with a demagnification factor that makes the beam on the workpiece cover at least two pixels; and
scanning the beam over a workpiece with a velocity which approximately matches the acoustic velocity in the modulator divided by the demagnification factor, whereby a stationary image of the pixels in the modulator is formed on the workpiece with interference between adjacent pixels but not over long distances.

22. A synchronized laser scanning system with highly accurate optical writing of a pattern on a workpiece by means of at least one acoustooptically modulated laser beam comprising:
a rasterizer that converts input vector data to a pixel bitmap;
a digital modulator coupled to the rasterizer, wherein the digital modulator computes sample points of a wave form modulated with pixel data that represent the pixel bitmap; and
a digital-to-analog converter, abbreviated DAC, coupled to the digital modulator, wherein the DAC converts the sample points to an analog radio frequency ("RF") signal suitable to drive a transducer of an acoustooptical modulator, further including:
a first clock controlling the loading of the pixel of the data and
a second clock controlling the sampling of the RF signal;
wherein the second clock operates at a frequency that is an integer multiple of the first clock's frequency so that the analog RF signal has a frequency that is an integer multiple of the image pattern data frequency.

23. The system of claim 22, further including:
a third clock signal controlling the loading of frequency data for the acoustooptic deflector; and
a fourth clock signal controlling the sampling of the RF to the deflector,
wherein all four clock signals are synchronized.

24. The system of any of claims 22-23, further including:
providing an acoustooptic modulator having an acoustic velocity;
providing projection optics with a demagnification factor that makes the beam on the workpiece cover at least two pixels; and
providing an acoustooptical deflector with a chirp that is digitally synthesized and synchronized to a clock used to generate the digital wave form, wherein the acoustooptical deflector is configured for deflecting the beam so that the beam is scanning over the workpiece with a velocity which approximately matches the acoustic velocity in the modulator divided by the demagnification factor, whereby a stationary image of the pixels in the modulator is formed on the workpiece with interference between adjacent pixels but not over long distances.

## Patentansprüche

1. Verfahren zum Bereitstellen eines synchronisierten Laserscansystems durch Vereinfachung des Betriebs eines akusto-optischen Modulators, abgekürzt AOM, der zum Modellieren eines Laserstrahls und zum Verbessern der Phasensteuerung des Laserstrahls verwendet wird, umfassend:
digitales Berechnen von Probepunkten einer Wellenform mit Wellenform-Amplitudenmodulation und Phasensteuerung, die Bildmusterdaten repräsentieren;
Bereitstellen eines Digital-Analog-Konverters, abgekürzt DAC, zum Konvertieren der digitalen Wellenform-Probenpunkte in ein analoges Hochfrequenz-, abgekürzt HF, Signal, wobei das analoge HF-Signal eine Frequenz hat, die ein ganzzahliges Vielfaches der Bildmuster-Datenfrequenz ist; und
Anwenden des analogen HF-Signals auf einen AOM-Transducer, um einen Laserstrahl zu modulieren und ein Bild zu erzeugen.

2. Verfahren nach Anspruch 1, wobei die Bildmusterdaten bei einer Frequenz im Bereich von 50 MHz bis 100 MHz ausgegeben werden.

3. Verfahren nach Anspruch 1, das ferner das Wechseln zwischen positiven und negativen Amplituden zwischen aufeinanderfolgenden Ausgabepixeln der Bildmusterdaten umfasst;
wobei destruktive Interferenz zwischen den positiven und negativen Amplituden der aufeinanderfolgenden Ausgabepixel einen dunklen Bereich zwischen weißen Flächen der aufeinanderfolgenden Ausgabepixel erzeugt.

4. Verfahren nach Anspruch 1, das ferner die Verwendung mehrerer FPGAs umfasst, um gemultiplexte Probepunkte der Wellenform zu erzeugen.

5. Verfahren nach Anspruch 1, wobei eine ganze Zahl von Probepunkten pro Zyklus der digitalen Wellenform berechnet wird.

6. Verfahren nach Anspruch 1, wobei vier Probenpunkte pro Zyklus der digitalen Wellenform berechnet werden.

7. Verfahren nach Anspruch 1, wobei der DAC mit einem ganzzahligen Vielfachen einer Frequenz der digitalen Wellenform getaktet ist.

8. Verfahren nach Anspruch 1, wobei die Wellenlänge der digitalen Wellenform ein ganzzahliges Vielfaches der verfügbaren Phasensteuerungsverschiebung der digitalen Wellenform ist.

9. Verfahren nach Anspruch 1, wobei die Phasensteuerungsverschiebung die digitale Wellenform durch Mehrfache von 90° relativer Phase verschiebt.

10. Verfahren nach Anspruch 1, das ferner das Modulieren der Wellenform umfasst, um den Laserstrahl durch destruktive Interferenz über einem Kristall des AOM auszulöschen.

11. Verfahren nach Anspruch 1, das ferner das Reduzieren der Ausgabe-HF-Energievariation auf eine Hälfte der Energievariation umfasst, die aus der Verwendung von konstanter Phase und Amplitude zum Erzeugen von grauen Pixeln resultiert.

12. Verfahren nach Anspruch 1, das ferner das Abwechseln zwischen positiven und negativen Amplituden innerhalb eines Ausgabepixels der Bildmusterdaten umfasst.

13. Verfahren nach Anspruch 12, das ferner im Wesentlichen das Auslöschen des Laserstrahls durch destruktive Interferenz durch Wechseln zwischen positiven und negativen Amplituden innerhalb eines Ausgabepixels der Bildmusterdaten umfasst.

14. Verfahren nach Anspruch 12, das ferner im Wesentlichen das Auslöschen des Laserstrahls durch destruktive Interferenz durch Abwechseln zwischen positiven und negativen Amplituden in aufeinanderfolgenden Ausgabepixeln der Bildmusterdaten umfasst.

15. Verfahren nach Anspruch 12, das ferner den Grauabgleich des Laserstrahls durch destruktive Interferenz durch Abwechseln zwischen positiven und negativen Amplituden innerhalb eines Ausgabepixels der Bildmusterdaten umfasst.

16. Verfahren nach Anspruch 15, das ferner das Aufrechterhalten einer im Wesentlichen konstanten HF-Energie umfasst, wenn zwischen den positiven und negativen Amplituden gewechselt wird, relativ zur HF-Energie, die angewendet wird, wenn ein weißes Pixel des Laserstrahls erzeugt wird.

17. Verfahren nach Anspruch 1, das ferner das Lenken des Laserstrahls durch einen akusto-optischen Deflektor umfasst, wobei der akusto-optische Deflektor einen Chirp hat, der digital synthetisiert wird und mit einer Uhr synchronisiert ist, die zum Erzeugen der digitalen Wellenform verwendet wird.

18. Verfahren nach einem der Ansprüche 1 - 17, das ferner das Verwenden des Verfahrens zum Schreiben von feinen Mustern in einer optischen Schreibvorrichtung umfasst, die ein eindimensionales optisches Feld mit einer Längs- und Querrichtung hat, welches in der Querrichtung scannt, wobei das Verfahren die folgenden Aktionen umfasst:
Aufnehmen eines Musters, in dem die feinen Linien so eingeschränkt sind, dass sie innerhalb 30° der Parallele zur Querrichtung des optischen Feldes verlaufen, wobei das eindimensionale optische Feld speziell kohärent in der Längsrichtung ist;
Rastern eines Musters derart, dass Übergänge im Muster in der Längsrichtung von Hell zu Dunkel eine Umkehr in einem Vorzeichen des Realteils einer Amplitude von Pixeldaten verursacht, die durch das Rastern erzeugt wurden, und
Modulieren von Licht im eindimensionalen optischen Feld zu einer komplexen Amplitude, wo der Realteil der komplexen Amplitude dem Vorzeichen der Pixeldaten folgt, wodurch Linien-Raum-Muster bis zu etwa 0,25 * Wellenlänge/NA aufgelöst werden können.

19. Verfahren nach Anspruch 18, wobei die feinen Linien weiter so eingeschränkt werden, dass sie innerhalb von 15 Grad der Parallele zur Querrichtung verlaufen.

20. Verfahren nach Anspruch 18, erweitert auf Schreiben im Dualmodus, das ferner umfasst:
Bereitstellen eines zweiten Schreibmodus, bei dem der Rasterizer Pixeldaten mit nur negativen Realteilen der Amplitude rendert; und
Umschalten zwischen den Modi durch Ändern des Algorithmus, der vom Rasterizer verwendet wird, wodurch der neue hochauflösende Modus einem System zugefügt wird, ohne die Flexibilität und die Bildqualität des konventionellen Schreibens zu opfern.

21. Verfahren nach Anspruch 18, das ferner die Verwendung des Verfahren zum Erzeugen eines teilweise kohärenten Schreibzustandes in einem Raster-Scanning-Laserschreiber umfasst, umfassend:
Bereitstellen eines akusto-optischen Modulators, der eine akustische Geschwindigkeit hat;
Verwenden von Projektionsoptik mit einem Verkleinerungsfaktor, der bewirkt, dass der Strahl auf dem Werkstück mindestens zwei Pixel abdeckt; und
Scannen des Strahls über ein Werkstück mit einer Geschwindigkeit, die annähernd der akustischen Geschwindigkeit im Modulator entspricht, geteilt durch den Verkleinerungsfaktor, wodurch ein stationäres Bild der Pixel im Modulator auf dem Werkstück mit Interferenz zwischen benachbarten Pixeln gebildet wird, aber nicht über größere Distanzen.

22. Synchronisiertes Laserscansystem mit hochgenauem optischem Schreiben eines Musters auf einem Werkstück mittels mindestens eines akusto-optisch modulierten Laserstrahls, umfassend:
einen Rasterizer, der eingegebene Vektordaten in ein Pixel-Bitmap konvertiert;
einen digitalen Modulator, der mit dem Rasterizer verbunden ist, wobei der digitale Modulator Probenpunkte einer Wellenform berechnet, die mit Pixeldaten moduliert werden, welche die Pixel-Bitmap repräsentieren; und
einen Digital-Analog-Konverter, abgekürzt DAC, der mit dem digitalen Modulator verbunden ist, wobei der DAC die Probenpunkte in ein analoges Hochfrequenz-("HF")Signal umwandelt, das sich dafür eignet, einen Transducer eines akusto-optischen Modulator zu steuern, der Folgendes umfasst:
eine erste Uhr, die das Laden der Pixel der Daten steuert, und
eine zweite Uhr, die das Abtasten des HF-Signals steuert;
wobei die zweite Uhr bei einer Frequenz arbeitet, die ein ganzzahliges Vielfaches der Frequenz der ersten Uhr ist, sodass das analoge HF-Signal eine Frequenz hat, die ein ganzzahliges Vielfaches der Bildmuster-Datenfrequenz ist.

23. System nach Anspruch 22, ferner umfassend:
ein drittes Uhrensignal, das das Laden von Frequenzdaten für den akusto-optischen Deflektor steuert; und
ein viertes Uhrensignal, das die Abtastung der HF zum Deflektor steuert,
wobei alle vier Uhrensignale synchronisiert sind.

24. System nach einem der Ansprüche 22 - 23, ferner umfassend:
Bereitstellen eines akusto-optischen Modulators, der eine akustische Geschwindigkeit hat;
Verwenden von Projektionsoptik mit einem Verkleinerungsfaktor, der bewirkt, dass der Strahl auf dem Werkstück mindestens zwei Pixel abdeckt; und
Bereitstellen eines akusto-optischen Deflektors mit einem Chirp, der digital synthetisiert und mit einer Uhr synchronisiert ist, die zum Erzeugen der digitalen Wellenform verwendet wird, wobei der akusto-optische Deflektor dafür ausgelegt ist, den Strahl so abzulenken, dass der Strahl das Werkstück mit einer Geschwindigkeit abtastet, die annähernd mit der akustischen Geschwindigkeit im Modulator übereinstimmt, geteilt durch den Verkleinerungsfaktor, wobei ein stationäres Bild der Pixel im Modulator auf dem Werkstück mit Interferenz zwischen benachbarten Pixeln gebildet wird, aber nicht über größere Distanzen.

## Revendications

1. Procédé de fourniture d'un système de balayage laser synchronisé en simplifiant le fonctionnement d'un modulateur acousto-optique AOM, soit AcoustoOptical Modulator, utilisé pour moduler un faisceau laser et améliorer le contrôle de phase du faisceau laser, incluant :
le calcul numérique de points d'échantillonnage d'une forme d'onde avec une modulation d'amplitude de forme d'onde et un contrôle de phase qui représentent des données de motif d'image ;
la fourniture d'un convertisseur numérique-analogique DAC, soit Digital-to-Analog Converter, pour convertir les points d'échantillonnage de la forme d'onde numérique en un signal de radiofréquence, RF, analogique, dans lequel le signal RF analogique possède une fréquence qui est un multiple entier de la fréquence des données de motif d'image ; et
l'application du signal RF analogique à un transducteur AOM pour moduler un faisceau laser et créer une image.

2. Procédé selon la revendication 1, dans lequel les données de motif d'image sont sorties à une fréquence comprise dans une plage de 50 MHz à 100 MHz.

3. Procédé selon la revendication 1, incluant en outre l'alternance entre des amplitudes positives et négatives entre des pixels de sortie successifs des données de motif d'image ;
dans lequel une interférence destructrice entre les amplitudes positives et négatives des pixels de sortie successifs produit une zone sombre entre des zones blanches des pixels de sortie successifs.

4. Procédé selon la revendication 1, incluant en outre l'utilisation de multiples FPGA pour produire des points d'échantillonnage multiplexés de la forme d'onde.

5. Procédé selon la revendication 1, dans lequel un nombre entier de points d'échantillonnage sont calculés par cycle de la forme d'onde numérique.

6. Procédé selon la revendication 1, dans lequel quatre points d'échantillonnage sont calculés par cycle de la forme d'onde numérique.

7. Procédé selon la revendication 1, dans lequel le DAC est synchronisé sur un multiple entier d'une fréquence de la forme d'onde numérique.

8. Procédé selon la revendication 1, dans lequel la longueur d'onde de la forme d'onde numérique est un multiple entier du décalage de contrôle de phase disponible de la forme d'onde numérique.

9. Procédé selon la revendication 1, dans lequel le décalage de contrôle de phase décale la forme d'onde numérique d'une phase relative égale à des multiples de 90 degrés.

10. Procédé selon la revendication 1, incluant en outre la modulation de la forme d'onde pour éteindre le faisceau laser par interférence destructrice en traversant un cristal du modulateur AOM.

11. Procédé selon la revendication 1, incluant en outre la réduction de la variation de puissance RF de sortie à la moitié de la variation de puissance résultant de l'utilisation d'une phase et d'une amplitude constantes pour produire des pixels gris.

12. Procédé selon la revendication 1, incluant en outre l'alternance entre des amplitudes positives et négatives dans un pixel de sortie des données de motif d'image.

13. Procédé selon la revendication 12, incluant en outre essentiellement l'extinction du faisceau laser par interférence destructrice en alternant entre des amplitudes positives et négatives dans un pixel de sortie des données de motif d'image.

14. Procédé selon la revendication 12, incluant en outre essentiellement l'extinction du faisceau laser par interférence destructrice en alternant entre des amplitudes positives et négatives dans des pixels de sortie successifs des données de motif d'image.

15. Procédé selon la revendication 12, incluant en outre la transformation en échelle de gris du faisceau laser par interférence destructrice en alternant entre des amplitudes positives et négatives dans un pixel de sortie des données de motif d'image.

16. Procédé selon la revendication 15, incluant en outre le maintien d'une puissance RF essentiellement constante lors de l'alternance entre les amplitudes positives et négatives, par rapport à la puissance RF appliquée lors de la génération d'un pixel blanc du faisceau laser.

17. Procédé selon la revendication 1, comprenant en outre le pointage du faisceau laser à travers un déflecteur acousto-optique, dans lequel le déflecteur acousto-optique comporte un chirp qui est synthétisé numériquement et synchronisé avec une horloge utilisée pour générer la forme d'onde numérique.

18. Procédé selon l'une quelconque des revendications 1 à 17, incluant en outre l'utilisation dudit procédé pour écrire des motifs de pas fin dans un dispositif d'écriture optique ayant un champ optique unidimensionnel avec une direction longitudinale et transversale qui balaie en direction transversale, le procédé incluant les actions suivantes :
réception d'un motif dans lequel de fines lignes de pas sont orientées à moins de 30 degrés d'une parallèle à la direction transversale du champ optique, dans lequel le champ optique unidimensionnel est partiellement cohérent en direction longitudinale ;
rastérisation d'un motif de telle sorte que les transitions dans le motif en direction longitudinale de la lumière à l'obscurité provoquent une inversion de signe de la partie réelle d'une amplitude de données de pixel générée par la rastérisation, et
modulation de la lumière dans le champ optique unidimensionnel avec une amplitude complexe où la partie réelle de l'amplitude complexe suit le signe des données de pixel, moyennant quoi des motifs ligne-espace peuvent être résolus jusqu'à environ 0,25 * longueur d'onde / ouverture numérique.

19. Procédé selon la revendication 18, dans lequel les fines lignes de pas sont en outre orientées à moins de 15 degrés d'une parallèle à la direction transversale.

20. Procédé selon la revendication 18 étendu à l'écriture en mode double, comprenant en outre :
la fourniture d'un deuxième mode d'écriture où le rastériseur procure un rendu de données de pixel avec uniquement les parties réelles non négatives de l'amplitude ; et
la commutation entre les modes en changeant l'algorithme utilisé par le rastériseur, moyennant quoi le nouveau mode de haute résolution est ajouté à un système sans sacrifier la flexibilité et la qualité d'image de l'écriture conventionnelle.

21. Procédé selon la revendication 18, comprenant en outre l'utilisation dudit procédé pour créer une condition d'écriture partiellement cohérente dans un dispositif d'écriture laser à balayage de trame, incluant :
la fourniture d'un modulateur acousto-optique ayant une vitesse acoustique ;
l'utilisation d'un système optique de projection avec un facteur de réduction grâce auquel le faisceau parcourt la pièce de travail en couvrant au moins deux pixels ; et
le balayage du faisceau sur une pièce de travail à une vitesse qui correspond approximativement à la vitesse acoustique dans le modulateur divisée par le facteur de réduction, moyennant quoi une image stationnaire des pixels dans le modulateur est formée sur la pièce de travail avec une interférence entre des pixels adjacents mais pas sur de longues distances.

22. Système de balayage laser synchronisé avec écriture optique hautement précise d'un motif sur une pièce de travail à l'aide d'au moins un faisceau laser modulé acousto-optiquement, comprenant :
un rastériseur qui convertit des données vectorielles d'entrée en une image matricielle ;
un modulateur numérique couplé au rastériseur, dans lequel le modulateur numérique calcule des points d'échantillonnage d'une forme d'onde modulée avec des données de pixel qui représentent l'image matricielle ; et
un convertisseur numérique-analogique DAC couplé au modulateur numérique, dans lequel le DAC convertit les points d'échantillonnage en un signal de radiofréquence RF analogique adapté pour piloter un transducteur d'un modulateur acousto-optique, comprenant en outre :
une première horloge qui contrôle le chargement du pixel des données, et
une deuxième horloge qui contrôle l'échantillonnage du signal RF ;
dans lequel la deuxième horloge fonctionne à une fréquence qui est un multiple entier de la première fréquence d'horloge de telle sorte que le signal RF analogique possède une fréquence qui est un multiple entier de la fréquence des données de motif d'image.

23. Système selon la revendication 22, comprenant en outre :
un troisième signal d'horloge qui contrôle le chargement de données de fréquence pour le déflecteur acousto-optique ; et
un quatrième signal d'horloge qui contrôle l'échantillonnage du signal RF au déflecteur,
dans lequel les quatre signaux d'horloge sont tous synchronisés.

24. Système selon l'une quelconque des revendications 22 à 23, comprenant en outre :
la fourniture d'un modulateur acousto-optique ayant une vitesse acoustique ;
la fourniture d'un système optique de projection avec un facteur de réduction grâce auquel le faisceau parcourt la pièce de travail en couvrant au moins deux pixels ; et
la fourniture, sur un déflecteur acousto-optique, d'un chirp qui est synthétisé numériquement et synchronisé avec une horloge utilisée pour générer la forme d'onde numérique, dans lequel le déflecteur acousto-optique est configuré pour défléchir le faisceau de telle sorte que le faisceau balaie la pièce de travail à une vitesse qui correspond approximativement à la vitesse acoustique dans le modulateur divisée par le facteur de réduction, moyennant quoi une image stationnaire des pixels dans le modulateur est formée sur la pièce de travail avec une interférence entre des pixels adjacents mais pas sur de longues distances.
